# EUROPÄISCHE PATENTSCHRIFT

(11) **EP 3 240 381 B1**
(45) Veröffentlichungstag und Bekanntmachung des Hinweises auf die Patenterteilung: **01.04.2020**
(21) Anmeldenummer: 17165675.4
(22) Anmeldetag: 10.04.2017
(51) Int. Cl.: H05K 7/14

(54) **ELEKTRISCHES VERKETTUNGSMODUL FÜR EIN PNEUMATISCHES VENTILSYSTEM, STEUERUNGSEINHEIT FÜR EIN PNEUMATISCHES VENTILSYSTEM SOWIE VERFAHREN ZUR MONTAGE EINES ELEKTRISCHEN VERKETTUNGSMODULS**
ELECTRICAL LINKING MODULE FOR A PNEUMATIC VALVE SYSTEM, CONTROL UNIT FOR A PNEUMATIC VALVE SYSTEM AND METHOD FOR MOUNTING AN ELECTRIC LINKING MODULE
MODULE D'INTERCONNEXION ÉLECTRIQUE POUR UN SYSTÈME DE SOUPAPE PNEUMATIQUE, UNITÉ DE COMMANDE POUR UN SYSTÈME DE SOUPAPE PNEUMATIQUE ET PROCÉDÉ DE MONTAGE D'UN MODULE D'INTERCONNEXION ÉLECTRIQUE

(30) Priorität: 14.04.2016 DE 102016106932
(43) Veröffentlichungstag der Anmeldung: 01.11.2017
(73) Patentinhaber: TE Connectivity Industrial GmbH, 94559 Niederwinkling (DE)
(72) Erfinder: Pfeiffer, Wolfgang, 74653 Künzelsau (DE)
(74) Vertreter: Hofstetter, Schurack & Partner

(56) Entgegenhaltungen:
- DE-A1-102005 016 760
- DE-B4-102006 049 631
- DE-U1- 20 200 139
- US-A- 6 102 754
- US-A1- 2014 071 640
- US-A1- 2015 282 365

## Beschreibung

Die Erfindung betrifft ein Verfahren zur Montage eines elektrischen Verkettungsmoduls für ein pneumatisches Ventilsystem, bei welchem ein eckiges Gehäuse des Verkettungsmoduls mit einer in einer Gehäuseseite ausgebildeten Anbindungsöffnung zur Anbindung für ein zum Verkettungsmodul separates elektrisches Funktionsmodul bereitgestellt wird. In dem Gehäuse wird eine Mehrzahl von Verkettungskontakten, welche zur Verkettung des Verkettungsmoduls mit zumindest einem weiteren Verkettungsmodul ausgebildet sind, verbaut.

Die Erfindung betrifft auch ein elektrisches Verkettungsmodul für ein pneumatisches Ventilsystem. Das Verkettungsmodul umfasst ein eckiges Gehäuse, welches an einer Gehäuseseite eine Anbindungsöffnung für ein zum Verkettungsmodul separates elektrisches Funktionsmodul aufweist. Das elektrische Verkettungsmodul umfasst darüber hinaus eine Mehrzahl von Verkettungskontakten, welche zur Verkettung des Verkettungsmoduls mit zumindest einem weiteren dazu separaten Verkettungsmodul ausgebildet ist.

Darüber hinaus betrifft die Erfindung auch eine Steuerungseinheit für ein pneumatisches Ventilsystem mit zumindest einem elektrischen Verkettungsmodul. Des Weiteren betrifft die Erfindung auch ein pneumatisches Ventilsystem mit einer entsprechenden Steuerungseinheit.

Es ist bekannt, dass bei Produktionsanlagen in der Automatisierungstechnik oder Automobilindustrie als auch beispielsweise in der Produktionstechnik bei Schweißanlagen pneumatische Ventilsysteme vorhanden sind, welche somit eine fluidtechnische Ventilanordnung anbieten. Dazu sind spezifische Steuerungen erforderlich, die einerseits ausreichende elektrische Ströme zur Verfügung stellen können, andererseits umfängliche elektrische Steuerungen durchführen können. Dazu ist üblicherweise auch ein sogenannter Feldbus vorhanden.

Aus der DE 10 2005 016 760 A1 ist eine Anordnung elektrischer bzw. elektronischer Geräte bekannt. Darüber hinaus ist aus der DE 10 2006 049 631 B4 eine Signaleingabe-/ausgabevorrichtung bekannt.

Aus der US 6 102 754 A ist ein Stromschienenkontakt bekannt, der plattenartig bzw. als Streifen ausgebildet ist und endseitig mehrere Kontaktfinger aufweist.

Aus der DE 202 00 139 U1 ist ein Gehäuse zur Aufnahme zumindest einer Platine bekannt.

Aus der DE 103 04 324 A1 ist eine elektrische Anschlussvorrichtung und ein damit ausgestattetes elektrofluidisches Steuergerät bekannt. Die Anschlussvorrichtung umfasst einen sich in einer Verkettungsrichtung erstreckenden Verkettungsstrang, der sich aus mehreren, in der Verkettungsrichtung aufeinanderfolgenden Verkettungsmodulen zusammensetzt. Die Verkettungsmodule weisen jeweils eine Mehrzahl von Verkettungskontakten auf. Mittels der elektrischen Anschlussvorrichtung erfolgt eine Übermittlung serieller Signale zu und/oder von in einer Reihe angeordneten elektrischen Verbrauchern.

Darüber hinaus ist aus der EP 1 484 511 A1 ein elektrisches Verkettungsmodul zur Ansteuerung eines elektrischen Ventilantriebs einer fluidtechnischen Ventilanordnung bekannt. Dieses Verkettungsmodul kann mit weiteren Verkettungsmodulen batterieartig verkettbar sein und umfasst ein eckiges Gehäuse. Die Verkettungskontakte sind nur seitlich an dem Gehäuse zur elektrischen Kontaktierung mindestens eines weiteren Verkettungsmoduls ausgebildet. Diese Verkettungskontakte sind jeweils auch nur an einer Seite von gegenüberliegenden Seiten des Verkettungsmoduls angeordnet, wobei diese Verkettungskontakte noppenartig ausgebildet sind. Das Gehäuse ist dort als räumlicher Schaltungsträger ausgebildet.

Bei den bekannten Ausführungen ist die Montage des Verkettungsmoduls sehr aufwendig, da die einzelnen Komponenten, insbesondere die Verkettungskontakte, individuell verbaut werden müssen. Daraus entstehen erhebliche Montagetoleranzen, und die Montagedauer ist sehr lang.

Darüber hinaus sind diese bekannten Verkettungsmodule im Hinblick auf elektrische Kennparameter und deren jeweilige Werte limitiert.

Es ist Aufgabe der vorliegenden Erfindung, ein Verfahren zur Montage eines elektrischen Verkettungsmoduls zu schaffen, bei welchem der Montageaufwand reduziert ist und die Funktionalität des elektrischen Verkettungsmoduls verbessert ist. Es ist Aufgabe der vorliegenden Erfindung, ein elektrisches Verkettungsmodul, eine Steuereinheit mit einem derartigen elektrischen Verkettungsmodul als auch ein pneumatisches Ventilsystem zu schaffen, welches bzw. welche diesbezüglich verbessert ist.

Diese Aufgabe wird durch ein Verfahren und ein elektrisches Verkettungsmodul gemäß den unabhängigen Ansprüchen gelöst.

Bei einem erfindungsgemäßen Verfahren zur Montage eines elektrischen Verkettungsmoduls für ein pneumatisches Ventilsystem wird ein eckiges Gehäuse des Verkettungsmoduls mit einer in einer Gehäuseseite ausgebildeten Anbindungsöffnung zur Anbindung für ein zum Verkettungsmodul separates elektrisches Funktionsmodul bereitgestellt. Die Anbindungsöffnung wird somit als durchgängiges Loch ausgebildet, durch welches somit von außerhalb des Verkettungsmoduls in das Innere geblickt werden kann beziehungsweise die Zugänglichkeit von außen in das Innere des Gehäuses uneingeschränkt ermöglicht ist.

Es wird eine Mehrzahl von Verkettungskontakten, welche zur Verkettung des Verkettungsmoduls mit zumindest einem weiteren Verkettungsmodul ausgebildet sind, in dem Gehäuse verbaut. Dieses weitere Verkettungsmodul ist ein zum Funktionsmodul unterschiedliches Modul. In dem Gehäuse des Verkettungsmoduls können somit an unterschiedlichen Seiten dieses Gehäuses unterschiedliche weitere Module, nämlich einerseits zumindest ein weiteres Verkettungsmodul, andererseits zumindest ein Funktionsmodul, angeschlossen werden, insbesondere direkt daran angeschlossen werden.

Ein wesentlicher Gedanke der Erfindung ist darin zu sehen, dass die Verkettungskontakte außerhalb des Gehäuses an einem Schaltungsträger in den Endpositionen bereits vormontiert werden und dadurch außerhalb des Gehäuses eine vormontierte Einsatzbaugruppe ausgebildet wird. Diese außerhalb des Gehäuses vormontierte Einsatzbaugruppe wird dann über diese Anbindungsöffnung in das Gehäuse eingesetzt, sodass in der Endposition der Einsatzbaugruppe im Inneren des Gehäuses sich Verkettungskontakte durch zumindest eine erste Durchführöffnung in einer ersten Seitenwand des Gehäuses nach außen erstrecken und durch zumindest eine zweite Durchführöffnung in einer zur ersten gegenüberliegenden zweiten Seitenwand sich diese Verkettungskontakte ebenfalls nach außen und somit außerhalb des Gehäuses erstrecken. Durch ein derartiges Montageverfahren wird die Herstellung und Fertigung eines elektrischen Verkettungsmoduls wesentlich vereinfacht. Indem nämlich nicht die Verkettungskontakte einzeln über die Durchführungsöffnungen in dem Gehäuse nach innen geführt werden müssen, ist die Montagezeit deutlich reduziert. Darüber hinaus ist die Wahrscheinlichkeit, einen Verkettungskontakt zu beschädigen, beispielsweise zu verbiegen, minimiert. Denn es wird nicht mehr der einzelne Verkettungskontakt als solcher und alleine über ein schwieriges Einfädeln von außen durch einen Durchführungsschlitz im Gehäuse vollzogen, sondern es wird ein gesamtes massives Zwischenmodul, nämlich die vormontierte Einsatzbaugruppe, zugrundegelegt. Darüber hinaus ist es somit nicht mehr vorgesehen und auch durch die Größe der vormontierten Einsatzbaugruppe nicht mehr möglich, dass die Verkettungskontakte von außen zunächst durch die Durchführ-öffnungen in das Innere des Gehäuses geführt werden. Im Gegenteil, es kann nur noch in vorteilhafter Weise diese gesamte Einsatzbaugruppe über die große Anbindungsöffnung eingesetzt werden.

Indem gemäß der Erfindung auch in neuartiger Weise ein gemeinsamer einziger Schaltungsträger für die ganzen Verkettungskontakte bereitgestellt wird, kann grundsätzlich erst nur das Verfahren ermöglicht werden, durch das eine derartige Einsatzbaugruppe überhaupt erzeugt wird. Diese wird dann auch noch in dieser vorteilhaften Ausgestaltung außerhalb des Gehäuses erzeugt, was für die Bestückung des Schaltungsträgers mit den Verkettungskontakten deutlich einfacher zu handhaben ist. Die Verkettungskontakte können nämlich in dem Zusammenhang wesentlich positionsgenauer auf dem Schaltungsträger angebracht werden, da die Zugänglichkeit einfacher ist. Darüber hinaus ist durch diese Vorgehensweise ein unerwünschtes Verbiegen der Verkettungskontakte verhindert. Die Verkettungskontakte können in dem Zusammenhang nämlich durch die Vormontage außerhalb des Gehäuses äußerst exakt zueinander und auch äußerst exakt zum Schaltungsträger ausgerichtet werden. Die dann bereits außerhalb des Gehäuses erreichten Endpositionen der Verkettungskontakte an dem Schaltungsträger begünstigen die weitere Montage und die Handhabung der Einsatzbaugruppe insbesondere bei den weiteren Montageschritten, bei denen dann die Einsatzbaugruppe bereits sich im Inneren des Gehäuses befindet.

Ein ganz besonderer Vorteil dieser vormontierten Einsatzbaugruppe ist auch darin zu sehen, dass diese Einsatzbaugruppe dann im Hinblick auf ihre Funktionstauglichkeit frühzeitig geprüft werden kann, nämlich dann, wenn sie noch gar nicht in dem Gehäuse verbaut ist. Auch dadurch lässt sich die Funktionsprüfung vereinfachen. Nicht zuletzt ist es dadurch auch ermöglicht, dass im Fehlerfalle dieser Einsatzbaugruppe diese einfacher und schneller repariert werden kann. Ist eine derartige Reparatur nicht möglich, so ist der Grad der Aussonderung im Hinblick auf die Bauteilzahl eines derartigen Verkettungsmoduls minimiert, denn es müssen dann nur der Schaltungsträger und die Verkettungskontakte entsorgt werden, und nicht das gesamte Verkettungsmodul.

Gerade dann, wenn sich, wie bei der Erfindung vorgesehen, ein Verkettungskontakt über eine eigene Länge erstreckt, die im Hinblick auf die Orientierung im Inneren des Gehäuses größer ist als die Breite des Inneren des Gehäuses, ist die Erfindung besonders vorteilhaft. Denn es muss bei einer derartigen Ausgestaltung dann erreicht werden, dass sich ein derartig länglich erstreckender Verkettungskontakt sowohl durch die erste Durchführungsöffnung als auch zugleich durch die zweite Durchführungsöffnung erstreckt. Da sich auf diesem Weg und aufgrund der plattenartigen beziehungsweise streifenartigen und somit relativ filigranen und dünnen Ausgestaltung eines derartigen Verkettungskontakts Verbiegungen bei der herkömmlichen Montage nicht vermeiden lassen, ist die Erfindung besonders vorteilhaft. Dieses Verbiegen kann durch die bereits vormontierte stabile Positionierung der Verkettungskontakte auf dem Schaltungsträger vermieden werden, und dennoch durch geschickte Montageschritte erreicht werden, dass in der Endposition des Schaltungsträgers und somit auch der Einsatzbaugruppe sich die Verkettungskontakte, die eine entsprechende Breite aufweisen, sich sowohl durch einen ersten Durchführungsschlitz als auch durch einen zweiten Durchführungsschlitz jeweils erstrecken. Dies bedeutet, dass, obwohl das Innenmaß des Gehäuses kleiner ist als eine derartige Breite eines Verkettungskontakts, dennoch das Einbringen der Einsatzbaugruppe in das Innere des Gehäuses und dort auch in die Endposition einfach und schnell erfolgen kann und dennoch die Beschädigungswahrscheinlichkeit des Schaltungsträgers und/oder eines Verkettungskontakts minimiert ist.

Darüber hinaus ist durch diese Ausgestaltung auch erreicht, dass die Verkettungskontakte in ihrer Endposition in gleicher definierter fester Position zueinander angeordnet sind, sodass sich die Enden der Verkettungskontakte an den ersten Durchführungsöffnungen quasi auf gleicher Lage befinden und auch die Enden der Verkettungskontakte, die sich durch die zweiten Durchführöffnungen erstrecken, ebenfalls auf gleicher Lage befinden. Ein unerwünschtes, zu weites nach außen Überstehen eines oder mehrerer Verkettungskontakte ist dadurch vermieden. Dies kann im Vergleich dazu bei einer Bestückung, bei welcher die Verkettungskontakte einzeln und separat von außen durch eine Durchführungsöffnung in das Innere des Gehäuses geführt werden, nicht vermieden werden.

Darüber hinaus wird durch die Erfindung erreicht, dass alle Verkettungskontakte gemeinsam und gleichzeitig montiert und in das Innere des Gehäuses eingebracht werden und auch gleichzeitig dann die jeweiligen individuellen Montageschritte zur Verbringung in die Endposition erfahren. Dadurch kann auch die Positionierung der gesamten Einsatzbaugruppe verbessert und einfacher erfolgen und die Positionsfixierung aller Verkettungskontakte gemeinsam und gleichzeitig erreicht werden.

Es wird die Einsatzbaugruppe in einer Schrägstellung, insbesondere zur Ebene, in der sich die Anbindungsöffnung erstreckt, durch die Anbindungsöffnung eintauchend eingeführt. In dieser Schrägstellung werden erste Enden der Verkettungskontakte zuerst in die Anbindungsöffnung eintauchend eingeführt. Diese ersten Enden der Verkettungskontakte sind insbesondere platte und ebene Bereiche, insbesondere Schwertkontaktbereiche. Sie weisen also keine separaten Kontaktfinger auf.

Durch diese Einführungsöffnung und die Schrägstellung der Einsatzbaugruppe werden die ersten Enden in erste Aufnahmeschlitze einer zur Aufnahme der Verkettungskontakte ausgebildeten Trägervorrichtung in dem Gehäuse eingeführt. Dazu werden diese ersten Aufnahmeschlitze als in Richtung der Anbindungsöffnung orientierte, geradlinige, erste Aufnahmeschlitze zum Hindurcherstrecken und Führen jeweils eines Verkettungskontakts ausgebildet. Diese ersten Aufnahmeschlitze werden im Bereich der ersten Seitenwand des Gehäuses angeordnet beziehungsweise ausgebildet, und diese ersten Aufnahmeschlitze werden in ihrer Höhenerstreckung betrachtet an ihren der Anbindungsöffnung zugewandten oberen Enden offen ausgebildet. Über diese oberen offenen Enden der ersten Aufnahmeschlitze werden die ersten Enden der Verkettungskontakte über diese oberen Enden eingefädelt beziehungsweise eingesteckt. Dieses Einfädeln erfolgt somit zumindest mit einem vektoriellen Bewegungsanteil, der sich in der Ebene erstreckt, in der sich auch der erste Aufnahmeschlitz erstreckt und somit auch in Richtung der Längserstreckung des ersten Aufnahmeschlitzes. Durch eine derartige Ausgestaltung kann gerade die relativ große Einsatzbaugruppe, die aufgrund der in Breitenrichtung des Gehäuses gesehen größeren Ausmaße der Verkettungskontakte nicht mit einer senkrechten Bewegung von oben in die Anbindungsöffnung eingeführt werden kann, da in dem Zusammenhang die Anbindungsöffnung nicht breit genug ist, dennoch besonders vorteilhaft und einfach eingesetzt werden. Da sich die ersten Aufnahmeschlitze insbesondere in eine Ebene erstrecken, die senkrecht zur Ebene orientiert ist, in der sich die Anbindungsöffnung erstreckt, ist eine derartige Schrägstellung und Einschwenkbewegung der Einsatzbaugruppe unter den zusätzlichen Randbedingungen, nämlich der Größe der Anbindungsöffnung insbesondere in Breitenrichtung und der Erstreckung der Verkettungskontakte in Breitenrichtung, besonders vorteilhaft. Darüber hinaus ist durch diese Ausgestaltung auch gewährleistet, dass sich alle Verkettungskontakte mit diesen ersten Enden auch in diese ersten Aufnahmeschlitze einfach einfädeln lassen, ohne dass sich Verspreizungen oder dergleichen ergeben könnten. Diese nach oben offenen ersten Aufnahmeschlitze bilden somit bei diesem Einfädeln auch eine gewisse seitliche Stütze für die jeweiligen Verkettungskontakte, sodass dann auch hier ein Verkippen der gesamten Einsatzbaugruppe um eine Achse, die sich in Richtung der Erstreckung der Verkettungskontakte erstreckt, verhindert werden kann.

Es kann somit ein Einfädeln erfolgen, bei welchem die bereits in die ersten Aufnahmeschlitze in deren Längsrichtung bereichsweise eingefädelten Verkettungskontakte über ihre gesamte Höhe noch nicht innerhalb der gesamten Höhe eines ersten Aufnahmeschlitzes angeordnet sind, und das weitere Einfädeln in Richtung der Höhenerstreckung eines Aufnahmeschlitzes problemlos erfolgen kann.

Vorzugsweise wird die Einsatzbaugruppe so weit mit den Verkettungskontakten in die ersten Aufnahmeschlitze eingefädelt, dass sich die ersten Enden der Verkettungskontakte durch die zumindest eine erste Durchführungsöffnung in einer Zwischendurchführstellung weiter nach außen erstrecken, als sie sich dann in der Endposition der Einsatzbaugruppe im Gehäuse nach außen erstrecken. Es wird also bewusst während der Montage eine Zwischenposition der Einsatzbaugruppe herbeigeführt, bei welcher sich diese Verkettungskontakte an der ersten Durchführungsöffnung erhaben nach außen erstrecken. Durch diese Ausgestaltung wird es dann erreicht, dass sich die in Breitenrichtung des Gehäuses größer dimensionierten Verkettungskontakte auch mit ihren den ersten Enden gegenüberliegenden zweiten Enden vollständig in das Innere des Gehäuses einsenken lassen. Gerade durch die spezifische Geometrie der ersten Aufnahmeschlitze wird dieses Montageszenario im besonderen Maße begünstigt.

Vorzugsweise wird nach dem Erreichen dieser Zwischendurchführstellung die Einsatzbaugruppe somit in das Gehäuse vollständig durch die Anbindungsöffnung in eine Montagezwischenlage eingeschwenkt. In dieser Montagezwischenlage befindet sich dann die Einsatzbaugruppe bereits vollständig im Inneren des Gehäuses. In dieser Zwischenmontagelage wird auch eine positionelle Einstellung der Einsatzbaugruppe erreicht, bei welcher die zweiten Enden der Verkettungskontakte in Höhenrichtung des Gehäuses betrachtet auf der Höhe der zweiten Durchführungsöffnungen positioniert sind, und zwar derart, dass sich die zweiten Enden mit ihrer Höhe vollständig in den Höhenausmaßen der zumindest einen zweiten Durchführungsöffnung befinden. Es muss also dann in dieser Zwischenmontagelage keine Höhenanpassung der Einsatzbaugruppe dahingehend durchgeführt werden, dass die Verkettungskontakte mit ihrer Höhe vollständig innerhalb der Höhe der zweiten Durchführungsöffnung wären. Damit ist die Komplexität der weiteren Montageschritte ab dieser Zwischenmontagelage deutlich reduziert. Insbesondere kann dann auch vermieden werden, dass ein zweites Ende eines Verkettungskontakts, insbesondere ein oder mehrere Kontaktfinger an einem derartigen zweiten Ende eines Verkettungskontakts außerhalb einer zweiten Durchführungsöffnung an einer Innenseite des Gehäuses beziehungsweise der zweiten Seitenwand anschlagen würde und sich dann verbiegen würde oder bei der weiteren Montage der Einsatzbaugruppe in die Endposition sich verklemmen oder verspreizen würde.

In dieser Zwischenmontagelage sind die zweiten Enden noch vollständig außerhalb der zweiten Aufnahmeschlitze der Trägervorrichtung und somit auch insbesondere noch außerhalb der zweiten Durchführungsöffnung in dem Gehäuse. Diese zweiten Enden der Verkettungskontakte befinden sich in dieser Zwischenmontagelage daher vollständig im Inneren des Gehäuses, was auch durch die weiter nach außen geschobene Position der Einsatzbaugruppe auf der gegenüberliegenden ersten Seite und dem weiter nach außen sich Erstrecken der ersten Enden der Verkettungskontakte durch die ersten Durchführungsöffnungen in der ersten Seitenwand ergibt.

In einer vorteilhaften Ausführung wird die Einsatzbaugruppe dann ausgehend von dieser Zwischenlage beziehungsweise der Zwischenmontagelage im Inneren des Gehäuses in Richtung der zweiten Durchführungsöffnung des Gehäuses so weit geradlinig und somit in Richtung der Erstreckung der Verkettungskontakte verschoben, bis sich die zweiten Enden der Verkettungskontakte durch die zweite Durchführungsöffnung hindurch nach außen erstrecken und die Endposition der Einsatzbaugruppe erreicht wird. Es ist somit ausgehend von dieser Zwischenmontagelage nur noch ein sehr einfaches Bewegungsszenario durchzuführen, um die Endposition der gesamten Einsatzbaugruppe in dem Gehäuse zu erreichen.

Bei diesem gesamten Montageszenario kann neben den oben genannten umfänglichen Vorteilen auch der Automatisierungsgrad der Fertigung deutlich erhöht werden. Dies hat dann Vorteile bezüglich der Montagedauer und auch der resultierenden Kosten.

In einer vorteilhaften Ausführung wird vorgesehen, dass der Schaltungsträger zumindest zeitweise bei der Montage der Einsatzbaugruppe in die Endposition auf Querstreben, die sich zwischen der ersten und der zweiten Seitenwand unterhalb der Einsatzbaugruppe in dem Gehäuse erstrecken, aufgesetzt wird. Dies ist in vielfacher Weise vorteilhaft. Diese Querstreben bilden somit zum einen bereits definierte Höhenlagen für die Einsatzbaugruppe, sodass auch ein gewisses Abstützen der Einsatzbaugruppe dann beim erfolgten Einfädeln gegeben ist. Auch für die weiteren Montageschritte im Hinblick auf das Einschränken der zweiten Enden der Verkettungskontakte durch die Anbindungsöffnung in das Innere des Gehäuses als auch dann zum Erreichen der Zwischenmontagelage sind diese Querstreben besonders hilfreich. Die Höhenlage dieser Zwischenmontageposition wird dadurch automatisch erreicht und definiert vorgegeben, wenn dann die Einsatzbaugruppe, insbesondere der Schaltungsträger, flächig mit einer Unterseite auf den Querstreben beziehungsweise einem oberen Rand der Querstreben aufliegt. Das weitere Bewegungsszenario, um ausgehend von der Zwischenlage in die Endposition zu gelangen, ist dann durch diese Querstreben unterstützt beziehungsweise geführt. Gerade dann, wenn die Zwischenmontagelage erreicht ist und der Schaltungsträger quasi dennoch beabstandet und erhaben oberhalb eines Bodens des Gehäuses, insbesondere oberhalb eines Bodens der Trägervorrichtung, positioniert ist, kann ein daran Schleifen oder Kratzen vermieden werden. Insbesondere ist es dann vorteilhaft, wenn die Verkettungskontakte mit Kontaktstiften in Kontaktlöchern des Schaltungsträgers verbaut sind und sich diese Kontaktstifte auch geringfügig durch die Kontaktlöcher nach unten über die Unterseite des Schaltungsträgers überstehend erstrecken. Auch diese überstehenden Kontaktstifte können dann im Weiteren ausgehend von der Zwischenmontagelage berührungslos zu diesem Boden des Gehäuses und dem Boden der Trägervorrichtung verschoben werden, sodass diese Kontaktstifte nicht beschädigt werden und auch die Verkettungskontakte nicht aus ihren bereits erreichten Endpositionen am Schaltungsträger herausgehoben werden.

In einer weiteren vorteilhaften Ausführung wird zumindest eine Querstrebe auf ihrem der Anbindungsöffnung zugewandten oberen Rand mit einer ersten Erhöhung ausgebildet. Diese erste Erhöhung erstreckt sich entlang der Erstreckung der Querstrebe über eine derart kürzere Länge, dass die restliche Auflagelänge der Querstrebe am oberen Rand größer als die Breite des Schaltungsträgers ist, jedoch maximal um 1 Prozent größer als die Breite des Schaltungsträgers ist. Beim Einführen der Einsatzbaugruppe über die Anbindungsöffnung und insbesondere beim Verschwenken der Einsatzbaugruppe in das Gehäuse zum Erreichen der Zwischenmontagelage liegt die Einsatzbaugruppe, insbesondere der Schaltungsträger, dann auf dieser ersten Erhöhung von oben auf. Dadurch wird bereits eine spezifische definierte Position in Richtung der Höhe des Gehäuses für die Einsatzbaugruppe erreicht, um die ersten Enden der Verkettungskontakte einfach in die Durchführungsöffnungen einsetzen und dann auch einschwenken zu können. Diese ersten Erhöhungen können somit quasi auch ein Auflagepodest beziehungsweise ein Auflagelager bilden, an welches die daran abgestützte Einsatzbaugruppe sich verschwenken kann, um die Zwischenmontagelage zielführend zu erreichen.

Auch beim dann nachfolgenden Verschieben der Einsatzbaugruppe von der Zwischenmontageposition in die Endposition dient diese erste Erhöhung als gewisse von unten stützende Führungsschiene, auf welcher die Unterseite des Schaltungsträgers aufliegt.

In einer weiteren, besonders vorteilhaften Ausführung wird beim zumindest bereichsweise geradlinigen Verschieben der Einsatzbaugruppe der Schaltungsträger von der Zwischenmontageposition in die Endposition des Schaltungsträgers so weit verschoben, bis er von der ersten Erhöhung heruntergeschoben ist und dann in seiner Endposition mit seiner Unterseite nicht mehr auf dieser ersten Erhöhung aufliegt. Mit dem Erreichen der Endposition der Einsatzbaugruppe in dem Gehäuse liegt dann die Einsatzbaugruppe, insbesondere der Schaltungsträger mit seiner Unterseite, nur noch auf der Auflagelänge der Querstrebe auf, die in Höhenlage somit gegenüber der ersten Erhöhung nach unten versetzt ist. Durch diese Positionierung in der Endstellung der Einsatzbaugruppe ist der Schaltungsträger durch die erste Erhöhung in seiner Endposition seitlich gehalten. Diese diskrete Stufe, die am Übergang der ersten Erhöhung zu der Auflagefläche gebildet ist, stellt somit auch einen seitlichen Anschlag dar, sodass eine Bewegung des Schaltungsträgers in dieser Endposition in einer Bewegungsrichtung, die der Breitenrichtung des Gehäuses entspricht, gehemmt ist. Die Einsatzbaugruppe und insbesondere der Schaltungsträger würden dann mit einem schmalen Seitenrand an der ersten Erhöhung anschlagen.

Insbesondere durch die bereits oben genannte bevorzugte Dimensionierung der Auflagelänge, nämlich größer als die Breite des Schaltungsträgers, jedoch maximal um 1 Prozent größer als diese Breite des Schaltungsträgers, wird einerseits eine Presspassung des Schaltungsträgers in der Auflagelänge verhindert, sodass unerwünschte mechanische Spannungen und Krafteinwirkungen auf den Schaltungsträger verhindert werden können. Andererseits kann durch diese minimal größere Dimensionierung der Auflagelänge im Vergleich zur Breite des Schaltungsträgers eine dennoch geringfügig schwimmende Lagerung des Schaltungsträgers auf den Querstreben in der Endposition erreicht werden, aber eine unerwünschte innere Bewegungsfreiheit des Schaltungsträgers verhindert werden.

Vorzugsweise wird vorgesehen, dass die Auflagelänge an ihrem der ersten Erhöhung gegenüberliegenden Ende mit einer zweiten, an dem oberen Rand der Querstrebe ausgebildeten Erhöhung begrenzt wird, sodass der Schaltungsträger diesbezüglich schwimmend mit der Auflagelänge auf der Querstrebe in seiner Endposition gelagert wird. Die erste Erhöhung ist an einem in das Innere ragenden Überstand der Trägervorrichtung ausgebildet, wobei sich dieser Überstand weiter in das Innere erstreckt als ein zweiter Aufnahmeschlitz. Die zweite Erhöhung mündet somit nicht an eine Fläche, an der auch ein erster Aufnahmeschlitz mündet, sondern diese zweite Erhöhung mündet an diesen Überstand, sodass in Breitenrichtung des Gehäuses betrachtet zwischen einem Eingang eines zweiten Aufnahmeschlitzes und einem dem zweiten Aufnahmeschlitz zugewandten Ende einer derartigen zweiten Erhöhung ein Distanzelement, nämlich der Überstand, ausgebildet ist.

Vorzugsweise ist vorgesehen, dass der Schaltungsträger nach dem Erreichen seiner Endposition mit einer Vergussmasse umgeben wird, die auch in einen durch die Querstrebe erzeugten Freiraum zwischen dem Schaltungsträger und einen der Anbindungsöffnung gegenüberliegenden Boden des Gehäuses oder einem Boden der Trägervorrichtung eingebracht wird. Die Positionsfixierung der Einsatzbaugruppe und insbesondere des Schaltungsträgers wird dadurch verbessert. Insbesondere können damit auch Festigkeiten bis zu 140 g erreicht werden, sodass das Verkettungsmodul auch bei hohen mechanischen Kräften, insbesondere auch umfänglichen Vibrationen, standhält und dauerhaft uneingeschränkt funktionsfähig bleibt.

Vorzugsweise wird das Verkettungsmodul als Energieversorgungsmodul ausgebildet, und an dem Gehäuse wird ein Energieversorgungsanschluss mit einer Vielzahl von Energieversorgungskontakten ausgebildet. Nach dem Erreichen der Endposition der Einsatzbaugruppe in dem Gehäuse wird dann ein Stanzgitter in das Gehäuse eingesetzt, mit welchem der Schaltungsträger mit dem Energieversorgungsanschluss verbunden wird. Es ist in dem Zusammenhang durch das Stanzgitter dann eine Mehrzahl von Stanzgitterkontakten mit einem einstückigen Bauteil bereitgestellt, welches dann ebenfalls wiederum in einem einzigen Montageschritt in das Gehäuse eingebracht und dort in der Endlage befestigt werden kann. Insbesondere wird hier dann auch vorgesehen, dass Enden der Stanzgitterkontakte, von denen vier oder fünf Stanzgitterkontakte vorhanden sein können, in Kontaktlöcher des Schaltungsträgers eingepresst und/oder verlötet werden, insbesondere eine gasdichte Kontaktierung erzeugt wird. Andererseits wird dann auch vorzugsweise vorgesehen, dass Kontaktstifte der Energieversorgungskontakte über den Energieversorgungsanschluss eingeführt werden und mit den Stanzgitterkontakten individuell verbunden werden. Die verschiedenen Verbindungsmöglichkeiten wurden bereits oben genannt. Erst dann, wenn die Verbindung des Stanzgitters mit dem Schaltungsträger erzeugt wird und vorzugsweise auch erst dann, wenn die Verbindung des Stanzgitters mit den Energieversorgungskontakten beziehungsweise Kontaktstiften des Energieversorgungsanschlusses fest verbunden ist, werden die Stanzgitterkontakte des Stanzgitters separiert und die jeweils ausgebildeten Verbindungsstege getrennt, sodass die Stanzgitterkontakte im Bereich des ursprünglich zur Verfügung gestellten Stanzgitters nicht mehr miteinander verbunden sind.

Des Weiteren betrifft die Erfindung dann auch ein elektrisches Verkettungsmodul, welches nach einem erfindungsgemäßen Verfahren oder einer vorteilhaften Ausgestaltung davon ausgebildet ist. Insbesondere ist bei einem derartig hergestellten elektrischen Verkettungsmodul die Einsatzbaugruppe in der Endposition bezüglich der Anbringungsöffnung vollständig versenkt im Inneren des Gehäuses angeordnet. Die Verkettungskontakte sind somit mit oberen schmalen Rändern beziehungsweise mit oberen Kanten von der Anbindungsöffnung her frei zugänglich und somit auch der Anbindungsöffnung zugewandt angeordnet. Elektrische Kontakte eines Funktionsmoduls, welches dann an dem elektrischen Verkettungsmodul montiert wird, werden dann mit den Verkettungskontakten individuell elektrisch kontaktiert, indem sie sich direkt mechanisch an diese Verkettungskontakte anlegen beziehungsweise mit denen verbinden, wenn das Funktionsmodul in seine Endposition an dem Verkettungsmodul gebracht wird und dort befestigt wird.

Ein Funktionsmodul kann beispielsweise durch ein Verschrauben an dem Verkettungsmodul befestigt werden. Ebenso kann jedoch ein Anstecken oder ein Verrasten vorgesehen sein.

Ein erfindungsgemäßes elektrisches Verkettungsmodul für ein pneumatisches Ventilsystem umfasst ein eckiges Gehäuse. Das Gehäuse weist an einer Gehäuseseite eine Anbindungsöffnung zur Anbindung für ein zum Verkettungsmodul separates elektrisches Funktionsmodul auf. Die Anbindungsöffnung stellt somit quasi ein Loch dar, durch welches in das Innere des elektrischen Verkettungsmoduls die Zugänglichkeit erreicht ist. Das elektrische Verkettungsmodul ist somit mit einem Gehäuse ausgebildet, welches an einer Gehäuseseite dieser eckigen Geometrie nicht abgedeckt ist und zum Inneren des Gehäuses die Zugänglichkeit freigegeben ist. Insbesondere ist diese Anbindungsöffnung mit einer Größe ausgebildet, die zumindest 50 Prozent der Gesamtfläche dieser Gehäuseseite darstellt. Insbesondere ist vorgesehen, dass diese Fläche der genannten Gehäuseseite vollständig offen ist und sich somit die Anbindungsöffnung über diese gesamte Ausdehnung der Gehäuseseite erstreckt.

Die Anbindungsöffnung ist auch dahingehend spezifisch gestaltet, dass das separate Funktionsmodul daran angeflanscht werden kann und somit individuell daran befestigt werden kann. Die Befestigung des elektrischen Funktionsmoduls ist insbesondere zerstörungsfrei lösbar ausgebildet. Dadurch kann ein Trennen und Zusammenfügen des elektrischen Funktionsmoduls mit dem elektrischen Verkettungsmodul reversibel erfolgen, sodass das Verkettungsmodul individuell mit unterschiedlichen Funktionsmodulen bestückt werden kann. Auch zu Montage- und Wartungsarbeiten ist diese Ausgestaltung sehr vorteilhaft, da dann jeweils das elektrische Verkettungsmodul oder das elektrische Funktionsmodul alleine bearbeitet werden kann.

Vorzugsweise weist das elektrische Verkettungsmodul eine Mehrzahl von Verkettungskontakten auf. Diese Verkettungskontakte sind zur Verkettung des elektrischen Verkettungsmoduls mit zumindest einem weiteren, dazu separaten elektrischen Verkettungsmodul ausgebildet.

Dadurch kann eine individuelle Ausgestaltung einer Verkettung mit einer vielfältigen Anzahl von Verkettungsmodulen erfolgen. Bedarfsabhängig kann somit, insbesondere im Hinblick auf die Ausgestaltung des pneumatischen Ventilsystems, eine individuelle Anzahl von elektrischen Verkettungsmodulen zugrundegelegt werden, die allesamt dann miteinander batterieartig verbunden sind.

Ein wesentlicher Gedanke der Erfindung ist darin zu sehen, dass in dem Gehäuse des elektrischen Verkettungsmoduls eine zur Aufnahme der Verkettungskontakte ausgebildete Trägervorrichtung angeordnet ist. Die Trägervorrichtung weist in Richtung der Anbindungsöffnung orientierte geradlinige erste Aufnahmeschlitze auf. Diese ersten Aufnahmeschlitze sind zum Hindurcherstrecken und Führen jeweils eines Verkettungskontakts ausgebildet. Die im Bereich einer ersten Seitenwand des Gehäuses angeordneten ersten Aufnahmeschlitze weisen in ihrer Höhenerstreckung betrachtet an ihren der Anbindungsöffnung zugewandten oberen Enden Öffnungen auf. Diese Aufnahmeschlitze sind somit zur Anbindungsöffnung hin offen ausgebildet. Durch diese Aufnahmeöffnungen der Aufnahmeschlitze können die Verkettungskontakte von oben in die Aufnahmeschlitze eingefädelt werden.

Bei dieser Ausgestaltung sind somit die Aufnahmeschlitze nicht nur in ihrer üblichen Geometrie, bei welcher die Schlitzöffnung sich in einer Ebene vorzugsweise parallel zu dieser ersten Seitenwand erstreckt ausgebildet, sondern der Aufnahmeschlitz ist umlaufend betrachtet nicht vollständig geschlossen, sondern auf der der Anbindungsöffnung zugewandten Seite und somit diesem oberen Ende nicht geschlossen, sondern offen. Dies bedeutet, dass ein Aufnahmeschlitz als solcher durch quasi eine U-Geometrie begrenzt ist, wobei die Öffnung dieser U-Form zur Anbindungsöffnung hin orientiert ist. Das Einführen eines Verkettungskontakts ist somit nicht nur, wie bei umlaufend vollständig geschlossenen Aufnahmeschlitzen, in einer Einführrichtung senkrecht zur Ebene, in der sich der Aufnahmeschlitz erstreckt, möglich, sondern ein Verkettungskontakt kann somit auch über dieses offene obere Ende eingeschoben beziehungsweise eingeschwenkt werden, sodass ein diesbezüglicher Bewegungsanteil der Gesamtbewegung bei dieser Einführbewegung auch in der Ebene, in der sich der Aufnahmeschlitz erstreckt, gegeben ist.

Durch diese Ausgestaltung wird die Montage des Verkettungsmoduls wesentlich vereinfacht. Es kann nunmehr über die Anbindungsöffnung selbst das Einführen der Verkettungskontakte erfolgen, wodurch die Montage schneller wird und die lagegenaue Positionierung der Verkettungskontakte vereinfacht ist.

Vorzugsweise ist vorgesehen, dass die Trägervorrichtung zur Anbindungsöffnung hin erhaben ausgebildete und beabstandet und parallel zueinander orientierte Querstreben aufweist. Diese Querstreben sind zur Auflage eines die Verkettungskontakte aufnehmenden Schaltungsträgers ausgebildet. Dies ist dahingehend eine besonders vorteilhafte Ausführung, da somit der alle Verkettungskontakte aufnehmende Schaltungsträger in seiner Höhenlage im Gehäuse einerseits sehr genau angeordnet werden kann, andererseits dadurch auch kein unerwünschtes Verbiegen beziehungsweise Bombieren des Schaltungsträgers bei der Montage und auch über die Lebensdauer des Verkettungsmoduls auftritt. Dies hat dann wiederum auch wesentliche Vorteile bezüglich der Lagegenauigkeit der darauf angeordneten Verkettungskontakte insbesondere im Hinblick dann auf die Lage der Verkettungskontakte zueinander als auch bezüglich eines Erstreckens aus dem Gehäuse heraus.

Gerade die Lagegenauigkeit der Enden der Verkettungskontakte, die sich durch Durchführungsöffnungen in dem Gehäuse aus dem Gehäuse nach außen erstrecken, ist dann sehr genau möglich und dauerhaft aufrecht zu erhalten.

Diese Querstreben erstrecken sich vorzugsweise über die gesamte Breite des Gehäuses. Dadurch bieten sie auch Montagestützen für den Schaltungsträger. Denn insbesondere ist bei einer Ausgestaltung, bei welcher die Verkettungskontakte vor dem Einbringen in das Innere des Gehäuses auf den Schaltungsträger vormontiert werden und dadurch eine Einsatzbaugruppe umfassend den Schaltungsträger und die darauf montierten Verkettungskontakte bilden, eine zielführendere und lagegenauere Montage erreichbar. Denn dieses Montagezwischenmodul in Form der vormontierten Einsatzbaugruppe kann dann beim Einbringen über die Anbindungsöffnung bereits gezielt im Hinblick auf ihre Höhenlage auf die Querstreben aufgesetzt werden, sodass das Einfädeln der Verkettungskontakte in die Aufnahmeschlitze sowie das Hindurchführen der Verkettungskontakte durch die Aufnahmeschlitze und dann auch durch die Durchführungsöffnung des Gehäuses im gewissen Maße auch geführt ist. Es kann dadurch auch vermieden werden, dass dieser Schaltungsträger mit den Verkettungskontakten entweder zu weit unten im Gehäuse beim Montagevorgang positioniert werden würde, was sich dann gegebenenfalls in Verklemmungen oder Verspreizungen beim Einfädeln der Verkettungskontakte in die Aufnahmeschlitze und insbesondere beim Hindurchführen durch die Durchführungsöffnungen im Gehäuse wiederspiegeln würde. Dadurch könnten dann die Verkettungskontakte auch beschädigt werden.

Es kann vorgesehen sein, dass diese Querstreben am Boden des Gehäuses angeordnet sind. Diese können dann integral in dem Boden des Gehäuses ausgebildet sein.

Es kann jedoch auch vorgesehen sein, dass die Trägervorrichtung einen zum Boden des Gehäuses separaten Boden aufweist und diese Querstreben an dem Boden der Trägervorrichtung angeordnet, insbesondere integriert, sind.

Da das Gehäuse abhängig vom jeweiligen Anwendungsfall aus unterschiedlichen Materialien ausgebildet sein kann, kann bei unterschiedlichen Ausführungen vorgesehen sein, dass die Querstreben in den Boden des Gehäuses integriert sind, wenn das Material des Gehäuses und das Material der Querstrebe gleich sein können. Ist andererseits jedoch das Material des Gehäuses aus einem zu der Querstrebe individuellen Material und somit zu einem dazu unterschiedlichen Material bereitzustellen, ist es vorteilhaft, wenn die Querstrebe in einen zusätzlich vorhandenen Boden der Trägervorrichtung integriert ist.

In dem Zusammenhang kann es vorteilhaft sein, dass bei spezifischen Ausführungen das Gehäuse des Verkettungsmoduls aus einem Metall ausgebildet ist. Das Gehäuse kann dann beispielsweise ein Druckgussbauteil sein. Bei diesen Ausführungen ist es dann vorteilhaft, wenn die Querstrebe, die vorzugsweise aus Kunststoff ausgebildet ist, nicht in dem Boden des Gehäuses, sondern in einen Boden der Trägervorrichtung, der dann vorzugsweise ebenfalls aus Kunststoff ausgebildet ist, integriert ist.

Bei einer weiteren Ausführung, bei welcher das Gehäuse des Verkettungsmoduls aus Kunststoff ausgebildet sein kann, kann diese Querstrebe dann auch direkt in den Boden des Gehäuses integriert sein und eine Querstrebe aus Kunststoff sein.

Der Schaltungsträger ist bei einer Ausführung des elektrischen Verkettungsmoduls als elektrisches Energieversorgungsmodul als ebene Platine ausgebildet, die somit eine vorzugsweise eckige, insbesondere rechteckige, Platte ist, die eben ausgebildet ist. Bei einer Ausgestaltung als Energieversorgungsmodul weist das dargelegte Verkettungsmodul zusätzlich einen Energieversorgungsanschluss auf, mit welchem dann das Verkettungsmodul mit elektrischer Energie versorgt werden kann.

Bei einer Ausgestaltung, bei der ein Verkettungsmodul keinen derartigen Energieversorgungsanschluss aufweist, kann dieser Schaltungsträger dann auch eine zu einer plattenartigen Platine unterschiedliche Ausführung aufweisen und insbesondere auch ein Stanzgitter sein.

Bei einer vorteilhaften Ausführung ist vorgesehen, dass sich die Querstreben zumindest über die Breite des Schaltungsträgers zwischen zwei gegenüberliegenden und an die Anbindungsöffnung mündende erste Seitenwand und zweite Seitenwand des Gehäuses erstrecken. Durch diese Ausgestaltung wird eine weitere Montagevereinfachung erreicht. Denn dadurch wird insbesondere ermöglicht, dass das Einbringen des Schaltungsträgers mit den Verkettungskontakten über die Anbindungsöffnung bereits das höhengenaue Anbringen des Schaltungsträgers mit den Verkettungskontakten bei den weiteren Montagebewegungen, die zum Erreichen der Endposition des Schaltungsträgers mit den Verkettungskontakten im Inneren des Gehäuses durchgeführt werden müssen, vordefiniert ist. Darüber hinaus lässt sich durch diese explizite Erstreckung der Querstreben dann auch eine im Inneren des Gehäuses durchzuführende Horizontalverschiebung des Schaltungsträgers mit den Verkettungskontakten einfach durchführen, bis die Endposition erreicht ist. Diese Querstreben bedienen dann bei dieser spezifischen Montagebewegung hin zur Endposition von unten angreifende Führungsschienen, die diese Bewegungsführung in Breitenrichtung des Gehäuses dann definiert ermöglichen. Einfädelprobleme der Verkettungskontakte an den den ersten Aufnahmeschlitzen gegenüberliegenden zweiten Aufnahmeschlitzen der Trägervorrichtung als auch ein Hindurchführen der Verkettungskontakte durch den ersten Durchführungsöffnungen im Gehäuse gegenüberliegenden, zweiten Durchführungsöffnungen im Gehäuse können dadurch vermieden werden. Die äußerst zielgerichtete Verbringung des Schaltungsträgers mit den Verkettungskontakten in die Endposition im Gehäuse ist dadurch ermöglicht.

Vorzugsweise ist vorgesehen, dass zumindest eine Querstrebe an ihrem der Anbindungsöffnung zugewandten oberen Rand eine erste Erhöhung aufweist. Durch diese erste Erhöhung ist der Schaltungsträger in seine Endposition in der Trägervorrichtung in einer Richtung, in der sich die Querstrebe erstreckt, in seiner Bewegung gehindert. In dieser Endposition bildet somit diese erste Erhöhung einen seitlichen Anschlag, an dem ein schmaler Rand des Schaltungsträgers anschlagen kann. Durch diese Ausgestaltung ist die Endposition des Schaltungsträgers im Inneren des Gehäuses vorgegeben und ein unerwünschtes großes Verrutschen des Schaltungsträgers verhindert.

Insbesondere dann, wenn zur endgültigen Ausgestaltung des elektrischen Verkettungsmoduls auch noch eine Vergussmasse in das Innere des Gehäuses eingebracht wird und den Schaltungsträger zumindest bereichsweise umgibt, wird durch diese Ausgestaltung auch erreicht, dass beim Einbringen der Vergussmasse und dem Aushärten der Vergussmasse keine unerwünschte Positionsveränderung des Schaltungsträgers auftritt.

Durch diese erste Erhöhung ist die Querstrebe an ihrem oberen Rand und somit nicht über die gesamte Länge auf einem gleichen Höhenniveau ausgebildet, sondern umfasst insbesondere dadurch einen diskreten Sprung.

Diese erste Erhöhung bietet auch bei der Montage eine Erleichterung, da bei dem Montageschritt des horizontalen Verschiebens des Schaltungsträgers mit den darauf angeordneten Verkettungskontakten in Breitenrichtung des Gehäuses zum Hindurchführen der Verkettungskontakte durch zweite Aufnahmeschlitze der Trägervorrichtung und dann auch durch zweite Durchführungsöffnungen in dem Gehäuse eine gewisse Führung erreicht ist. Insbesondere wird dann auch die Endposition des Schaltungsträgers einfach erkannt, da der Schaltungsträger über diese erste Erhöhung quasi hinweggleitet und dann von der ersten Erhöhung quasi herunterrutscht und in einen dann nach unten versetzten Auflagebereich der Querstrebe hineingleitet. Es ist somit auch eine gewisse haptische Rückmeldung über das Erreichen der Endlage ermöglicht, wenn der Schaltungsträger die erste Erhöhung verlässt beziehungsweise über den Sprung zwischen der ersten Erhöhung und dem daran angrenzenden restlichen oberen Rand der Querstrebe schnappt.

In einer vorteilhaften Ausführung ist vorgesehen, dass die erste Erhöhung derart in Richtung der Querstrebe betrachtet angeordnet ist, dass ein von der ersten Erhöhung begrenzter Längenabschnitt der Querstrebe eine Länge aufweist, die maximal 1 Prozent größer ist als die Breite des Schaltungsträgers. Dies bedeutet somit, dass der gegenüber der ersten Erhöhung nach unten versetzte Längenabschnitt der Querstrebe den Schaltungsträger in seiner vollständigen Breite aufnehmen kann. Darüber hinaus ist jedoch diese Breite des Längenabschnitts und somit der Auflagelänge des oberen Rands dieser Querstrebe nur unwesentlich größer bemessen als diese Breite des Schaltungsträgers. Dadurch wird eine unerwünschte Bewegungstoleranz des Schaltungsträgers auf der Querstrebe in seiner Endposition verhindert. Dennoch ist durch diese Ausgestaltung eine Presspassung des Schaltungsträgers verhindert, sodass dieser nicht unerwünscht starken mechanischen Kräften ausgesetzt ist und sich daher auch nicht unerwünscht verformen kann. Eine diesbezüglich minimal schwimmende Lagerung des Schaltungsträgers in seiner Endposition auf den Querstreben weist daher mehrere, oben genannte Vorteile auf.

Vorzugsweise ist vorgesehen, dass dieser Längenabschnitt am oberen Rand der Querstrebe, der durch die erste Erhöhung eingefasst beziehungsweise begrenzt ist, an dem der ersten Höhe gegenüberliegenden Ende durch eine zweite Erhöhung an dem oberen Rand der Querstrebe begrenzt ist. Diese zweite Erhöhung erstreckt sich in Höhenrichtung weiter nach oben als die erste Erhöhung. Gerade dann, wenn bei dem Montagevorgang der Schaltungsträger mit den darauf angebrachten Verkettungskontakten in horizontaler Bewegungsrichtung zu den zweiten Aufnahmeschlitzen der Trägervorrichtung hin und somit auch zur zweiten Durchführung im Gehäuse hin bewegt wird, kann dann beim Erreichen der Endposition verhindert werden, dass sich der Schaltungsträger über diese zweiten Erhöhungen hinwegschiebt und somit wieder aus seiner eigentlichen Endposition verschoben werden würde. Ein zu weites Verschieben des Schaltungsträgers in Richtung der zweiten Aufnahmeschlitze ist dadurch verhindert. Insbesondere kann somit dann auch verhindert werden, dass die Verkettungskontakte zu weit aus den zweiten Durchführungsöffnungen nach außen stehen würden.

Vorzugsweise ist vorgesehen, dass die erste Erhöhung eine Höhe aufweist, die maximal 20 Prozent höher ist als die Dicke des Schaltungsträgers. Durch diese Ausgestaltung kann eine in Höhenrichtung sehr kompakte Ausführung des Gehäuses erreicht werden. Denn zum einen ist damit über die gesamte Höhe auch eine gewisse Erstreckung der ersten Aufnahmeschlitze ermöglicht. Andererseits ist damit dann auch erreicht, dass sich die Querstreben nicht über eine Höhe erstrecken, die mit einem der Anbindungsöffnung gegenüberliegenden Ende der Aufnahmeschlitze und somit einem unteren Ende der Aufnahmeschlitze in Höhenrichtung überlappen würden. Dies bedeutet, dass der obere Rand der Querstrebe und insbesondere auch der obere Rand der ersten Erhöhung auf der Querstrebe somit in Höhenrichtung betrachtet weiter unten liegen als ein unteres Ende der ersten Aufnahmeschlitze. Durch diese geringe Höhendimensionierung der ersten Erhöhung ist die Montage der Einsatzbaugruppe vereinfacht und auch der höhenkompakte Aufbau des Gehäuses erreicht. Darüber hinaus wird durch diese Ausgestaltung auch erreicht, dass beim Überführen des Schaltungsträgers über die erste Erhöhung und dann beim quasi Einschnappen in den gegenüber der ersten Erhöhung nach unten versetzten Längenabschnitt des oberen Rands der Querstrebe kein zu starkes nach unten Klappen beziehungsweise ein zu weites nach unten Schnappen des Schaltungsträgers auftritt. Eine unerwünschte Beschädigung des Schaltungsträgers ist dann vermieden.

Vorzugsweise ist vorgesehen, dass ein der Anbindungsöffnung zugewandter oberer Rand der ersten Erhöhung in Richtung der Anbindungsöffnung betrachtet unterhalb einem der Anbindungsöffnung abgewandten unteren Rand eines ersten Aufnahmeschlitzes ausgebildet ist. Dies birgt wesentliche Vorteile bei der Montage, da somit beim Einfädeln des Schaltungsträgers mit den darauf bereits montierten Verkettungskontakten durch die Anbindungsöffnung hindurch die Positionierung der Einsatzbaugruppe bereits dann mit einer gewissen Auflage auf der ersten Erhöhung ermöglicht ist, sodass die nachfolgenden Bewegungen beim Verbringen dieses Schaltungsträgers mit den Verkettungskontakten in die Endposition im gewissen Maße auch bezüglich der Höhenlage gestützt sind und nicht unerwünscht ein Hin- und Herpendeln dieses Einsatzmoduls beziehungsweise dieser vormontierten Einsatzbaugruppe erfolgt. Die Montage kann dadurch sehr schnell, zielgerichtet, fehlerminimiert und beschädigungsfrei für die jeweiligen Komponenten erfolgen.

Vorzugsweise ist vorgesehen, dass der Schaltungsträger mit einer Vergussmasse bedeckt ist, die auch zwischen dem Schaltungsträger und den durch die Querstreben gebildeten Freiräumen zwischen den Schaltungsträgern und einem Boden des Gehäuses oder einem Boden der Trägervorrichtung ausgebildet ist. Die Querstreben haben somit neben der Führungsfunktionalität und Auflagefunktionalität auch noch den Vorteil, dass sie eine gewisse Beabstandung des Schaltungsträgers zum Boden des Gehäuses und gegebenenfalls zum Boden der Trägervorrichtung bilden. Dadurch wird die Auflage des Schaltungsträgers minimiert, da die oberen Ränder der Querstreben minimale Flächen aufweisen und nur Linienabschnitte sind. Durch die Möglichkeit, dass auch die Vergussmasse in diese Freiräume eingebracht werden kann, wird die Lagefixierung des Schaltungsträgers verbessert. Dadurch können auch mechanische Kräfte, die beispielsweise durch Vibrationen im Betrieb des pneumatischen Ventilsystems auftreten können und sich auf das Verkettungsmodul übertragen können, problemlos aufgenommen. Auch kann dann ein Verzug oder eine Positionsveränderung aufgrund thermischer Einflüsse auf das Verkettungsmodul, wie sie auch im Betrieb auftreten können, verhindert werden. Insbesondere können in dem Zusammenhang auch elektrische Kennparameter des Verkettungsmoduls hochgehalten werden und mit geringen Schwankungen bereitgestellt werden, sodass die Funktionsstabilität und Betriebssicherheit des Verkettungsmoduls auch dauerhaft und langzeitig gegeben ist.

Vorzugsweise ist vorgesehen, dass die Trägervorrichtung in Richtung der Anbindungsöffnung orientierte zweite Aufnahmeschlitze aufweist, die zum Hindurcherstrecken und Führen jeweils eines Verkettungskontakts ausgebildet sind. Die im Bereich einer der ersten Seitenwand gegenüberliegenden zweiten Seitenwand des Gehäuses angeordneten zweiten Aufnahmeschlitze sind in ihrer Höhenerstreckung betrachtet an ihren der Anbindungsöffnung zugewandten oberen Enden geschlossen. Dadurch kann ein unerwünschtes nach oben Herausrutschen verhindert werden. Durch diese Kombination mit den nach oben offenen ersten Aufnahmeschlitzen und den nach oben geschlossenen zweiten Aufnahmeschlitzen wird ein besonders vorteilhaftes Montageverfahren ermöglicht, welches andererseits jedoch auch eine zuverlässige Sicherheit der Endlage beziehungsweise der Endposition des Schaltungsträgers mit den Verkettungskontakten im Gehäuse dauerhaft ermöglicht.

In einer vorteilhaften Ausführung ist vorgesehen, dass die zweiten Aufnahmeschlitze nicht geradlinig ausgebildet sind und zur Aufnahme von gebogenen Kontaktfingern des Verkettungskontakts ausgebildet sind. Diese unterschiedliche Geometrie der zweiten Aufnahmeschlitze zu den ersten Aufnahmeschlitzen ermöglicht eine relativ platzsparende Ausgestaltung dieser Aufnahmeschlitze für die jeweiligen Geometrien der Enden der Verkettungskontakte.

So sind die Verkettungskontakte vorzugsweise derart ausgebildet, dass sie sich an einem ersten Ende, welches sich durch die erste Aufnahmeschlitze und auch dann die ersten Durchführungsöffnungen erstrecken, als geradlinige, schwertartige Enden darstellen. An dem gegenüberliegenden Ende sind die Verkettungskontakte dann mit diesen nicht ebenen einzelnen Kontaktfingern ausgebildet. Durch die daran angepassten Geometrien der jeweiligen Aufnahmeschlitze kann bei minimalem Bauraum dennoch eine jeweilige, mit Spiel behaftete Durchführung der jeweiligen individuellen Enden der Verkettungskontakte durchgeführt werden. In dem Zusammenhang ist es dann auch ermöglicht, dass die in Höhenrichtung betrachtet dann jeweils in der Reihenfolge alternierend in unterschiedliche Richtungen gebogenen Enden der Kontaktfinger ein schwertartiges erstes Ende eines weiteren Verkettungskontakts eines anderen Verkettungsmoduls kontaktieren, insbesondere alternierend jeweils von gegenüberliegenden Seiten kontaktieren. Damit ist auch eine mechanisch stabile Verbindung zwischen zwei Verkettungskontakten von zwei unterschiedlichen Verkettungsmodulen ermöglicht.

In vorteilhafter Weise ist vorgesehen, dass die zweite Erhöhung an einen in das Innere des Gehäuses sich erstreckenden Überstand der Trägervorrichtung, der zwischen zwei zweiten Aufnahmeschlitzen ausgebildet ist, mündet. Durch diesen gegenüber den zweiten Aufnahmeschlitzen zu den ersten Aufnahmeschlitzen hin erhaben sich erstreckenden Überstand wird eine stabilere Basisstruktur für die zweite Erhöhung geschaffen, die auch entsprechende mechanische Kräfte aufnehmen kann.

Vorzugsweise ist vorgesehen, dass die Trägervorrichtung einstückig ausgebildet ist. Dadurch wird die Bauteilzahl des Verkettungsmodus wesentlich reduziert und somit auch der Montageaufwand erniedrigt. Darüber hinaus ist durch diese Ausgestaltung erreicht, dass die einzelnen Komponenten der Trägervorrichtung dauerhaft positionsfixiert zueinander angeordnet sind. Dadurch ist zum einen eine hohe Montagepräzision des Schaltungsträgers und der Verkettungskontakte ermöglicht und die dauerhafte Positionssicherheit dieser Komponenten dann an der Trägervorrichtung erreicht.

In einer vorteilhaften Ausführung ist vorgesehen, dass die Trägervorrichtung eine Wanne aus Kunststoff ist. In dem Zusammenhang ist dieses Bauteil dann auch mechanisch stabil und insbesondere in sich verwindungssteif ausgebildet. Darüber hinaus kann es sehr passgenau in das Gehäuse eingesetzt werden, sodass auch hier keine unerwünschten Toleranzen der Position zwischen dem Gehäuse und der Trägervorrichtung auftreten können. Vorzugsweise erstreckt sich diese Wanne dann auch über die gesamte Höhe bis hin zur Anbindungsöffnung, sodass der obere Rand der Trägervorrichtung und somit auch dieser Wanne, der der Anbindungsöffnung zugewandt ist, vorzugsweise bündig mit einem die Anbindungsöffnung begrenzenden oberen Rand des Gehäuses und somit der gegenüberliegenden Seitenwände als auch einer Vorderwand und einer Hinterwand des Gehäuses angeordnet ist.

Es kann die Trägervorrichtung dann auch einfach als Spritzgussbauteil hergestellt sein. Sie kann dann beispielsweise durch Kleben in dem Gehäuse befestigt sein. Auch andere Möglichkeiten der Befestigung sind vorgesehen, wobei dies dann abhängig von der Materialpaarung zwischen dem Material des Gehäuses und dem Material der Trägervorrichtung ist. Es kann in dem Zusammenhang auch ein Thermoschweißen vorgesehen sein oder ein einstückiges Ausbilden der Trägervorrichtung mit dem Gehäuse vorgesehen sein.

Vorzugsweise ist vorgesehen, dass an der Schnittstelle zwischen dem Verkettungsmodul und dem Funktionsmodul eine Dichtung angeordnet ist, die dann beispielsweise an dem oberen Rand der Trägervorrichtung und/oder an dem oberen Rand des Gehäuses angeordnet sein kann.

Vorzugsweise ist vorgesehen, dass die Trägervorrichtung stegartige Positionieranschläge zur Positionierung eines die Verkettungskontakte aufnehmenden Schaltungsträgers in seiner Längsrichtung aufweist. Diese Positionieranschläge sind an einer dritten Seitenwand beziehungsweise an einer Vorderwand und/oder einer Rückwand des Gehäuses ausgebildet. Eine derartige dritte Seitenwand beziehungsweise eine Vorderwand und/oder eine Rückwand sind an den gegenüberliegenden Rändern mit der ersten Seitenwand und der zweiten Seitenwand verbunden. Insbesondere erstreckt sich diese dritte Seitenwand parallel zu den sich zwischen der ersten und der zweiten Seitenwand erstreckenden Verkettungskontakten. Durch diese zusätzlichen Positionieranschläge wird nicht nur in Breitenrichtung des Gehäuses eine Positionssicherheit des Schaltungsträgers ermöglicht, sondern auch in einer dazu senkrechten Längsrichtung eine unerwünschte Positionsveränderung vermieden.

Vorzugsweise ist vorgesehen, dass die Verkettungskontakte plattenartig ausgebildet sind beziehungsweise streifenartige Elemente sind. Diese Verkettungskontakte weisen an einem ersten Ende einen glatten Rand auf, durch welchen ein schwertartiges Ende gebildet ist. An dem gegenüberliegenden zweiten Ende ist der Verkettungskontakt mit einer Mehrzahl von integrierten Kontaktfingern ausgebildet, die jeweils separate und beabstandete Kontaktfinger darstellen. Die damit erreichbaren Vorteile und die individuelle Verkettung des Verkettungsmoduls mit anderen Verkettungsmodulen sind dadurch erreicht.

In einer besonders vorteilhaften Ausführung ist vorgesehen, dass an dem zweiten Ende zumindest sieben separate Kontaktfinger ausgebildet sind. Dies ermöglicht eine wesentlich höhere Übertragung von elektrischen Strömen, sodass das Verkettungsmodul funktionsstabiler ist und andererseits auch für andere Anforderungen verwendbar ist, was bei herkömmlichen Ausführungen nicht gegeben war. Insbesondere ist dies dahingehend ein besonderer Vorteil, da auch diese zusätzlichen Einsatzgebiete ohne eine Vergrößerung des Verkettungsmoduls einhergehen.

Darüber hinaus ist eine deutlich bessere Stromsicherheit durch diese zumindest sieben Kontaktfinger ermöglicht. Unerwünschte Schwankungen des Stroms können dadurch vermieden werden und auch dauerhaft eine hohe Stromsicherheit aufrecht erhalten werden. Auch dies begünstigt dann die oben genannten Vorteile im Hinblick auf eine kompakte Bauform, um dennoch umfänglicheren und höheren Anforderungen an erforderlichen Einsatzgebieten gerecht zu werden.

Darüber hinaus wird durch diese Ausgestaltung auch eine geringere mechanische Steckkraft beim Verketten mit anderen Verkettungsmodulen ermöglicht.

Ein Kontaktfinger ist in dem Zusammenhang als laschenartiges Element gebildet, welches sich zunächst mit einem, von dem plattenartigen restlichen Bereich des Verkettungskontakts und einem von der Ebene dieses restlichen Bereichs des Verkettungskontakts abstehenden Haltesteg seitlich weg erstreckt. Dieser relativ kurze Haltesteg geht dann in einen bananenförmig gebogenen Endabschnitt eines Kontaktfingers über.

In Höhenrichtung des Verkettungskontakts betrachtet und somit in Richtung der Reihe, in der die zumindest sieben Kontaktfinger beabstandet zueinander angeordnet sind, weist der Verkettungskontakt eine Höhe auf, die insbesondere zwischen 0,85 cm und 0,95 cm beträgt.

In Höhenrichtung des Verkettungskontakts betrachtet und somit in Richtung der Reihe, in der die zumindest sieben Kontaktfinger beabstandet zueinander angeordnet sind, ist jeweils alternierend ein Haltesteg in eine erste Richtung von dem restlichen Bereich des Verkettungskontakts abstehend und ein dann benachbarter Haltesteg eines benachbarten Kontaktfingers in die andere Richtung von diesem restlichen ebenen Bereich des Verkettungskontakts abstehend. Auch diese bananenförmigen Endabschnitte sind dann jeweils in entgegengesetzte Richtungen gekrümmt. Dadurch wird die oben genannte geringere Steckkraft begünstigt und ein einfaches beidseitiges Umgreifen eines dann wiederum glatten ersten Endes eines anderen Verkettungskontakts eines anderen Verkettungsmoduls ermöglicht.

Es kann bei einer vorteilhaften Ausführung vorgesehen sein, dass sich die Verkettungskontakte durch die ersten Aufnahmeschlitze in der ersten Seitenwand des Gehäuses nach außen erstrecken und sich durch zweite Aufnahmeschlitze an einer der ersten Seitenwand gegenüberliegenden zweiten Seitenwand des Gehäuses aus dem Gehäuse nach außen erstrecken. Ein Verkettungskontakt in seiner einstückigen Ausgestaltung erstreckt sich somit über eine Breite, die größer ist, als die Breite des Inneren des Gehäuses. Es sind somit nicht jeweils separate, an den gegenüberliegenden Seitenwänden einzeln anbringbare Verkettungskontakte erforderlich. Durch diese spezifische Ausgestaltung des Verkettungskontakts der Erfindung wird auch wiederum die Montage vereinfacht und die oben genannten elektrischen Kennparameter werden begünstigt. Durch diese Ausgestaltung ist es dann auch erreicht, dass die elektrischen Verkettungskontakte als jeweils einstückiges Bauteil auch an gegenüberliegenden Seitenwänden des Gehäuses aufgenommen sind und positionell gehalten sind. Dadurch können unerwünschte Verbiegungen vermieden werden und die positionell exakte Anordnung erreicht und dauerhaft gewährleistet werden.

Vorzugsweise ist vorgesehen, dass die Verkettungskontakte Kontaktstifte aufweisen, mit welchen sie sich in Kontaktlöcher des Schaltungsträgers zur mechanischen Befestigung der elektrischen Kontaktierung erstrecken. Diese Kontaktstifte sind von einem schmalen Rand des Verkettungskontakts abstehend ausgebildet und erstrecken sich somit in der Ebene, in der sich der vorzugsweise ebene Verkettungskontakt erstreckt. Im montierten Zustand sind somit die Verkettungskontakte praktisch senkrecht zur Ebene des Schaltungsträgers orientiert und mechanisch stabil darauf befestigt. Es kann vorgesehen sein, dass diese Kontaktstifte in den Kontaktlöchern verpresst sind oder verstemmt sind. Zusätzlich kann auch vorgesehen sein, dass sie an den Kontaktlöchern auch noch verlötet sind.

In einer vorteilhaften Ausführung erstrecken sich die Kontaktstifte durch die Kontaktlöcher hindurch und erstrecken sich dann auf der gegenüberliegenden Seite des Schaltungsträgers auch noch aus den Kontaktlöchern bereichsweise heraus. Die mechanische Befestigung und auch die elektrische Kontaktierung sind dadurch verbessert. Gerade bei dieser Ausführung ist dann die bereits oben genannte vorteilhafte Ausgestaltung mit den Querstreben und den zwischen dem Schaltungsträger in seiner Endposition und einem Boden des Gehäuses ausgebildeten Freiräumen vorteilhaft. Denn dann können sich diese erhaben erstreckenden Kontaktstifte in die Freiräume erstrecken, ohne dass sie bereits am Boden anstehen würden und sich gegebenenfalls verbiegen würden und/oder ohne dass sich dann dadurch durch das bereits Aufliegen des Schaltungsträgers am Boden des Gehäuses die Verkettungskontakte wieder aus dem Schaltungsträger herausdrücken würden, wenn der Schaltungsträger in seiner Endposition im Gehäuse angeordnet wird. Auch die dann in diese Freiräume einbringbare Vergussmasse kann bei der oben genannten vorteilhaften Ausführung dann zusätzlich zur mechanischen Befestigung der Verkettungskontakte an den Schaltungsträger beitragen.

In einer vorteilhaften Ausführung ist es vorgesehen, dass das elektrische Verkettungsmodul als Energieversorgungsmodul ausgebildet ist und dazu zusätzlich einen externen Energieversorgungsanschluss aufweist.

Bei einer Verkettungsbatterie, die zumindest zwei Verkettungsmodule aufweist, ist es erforderlich, dass elektrische Energie zugeführt wird, sodass eines der Verkettungsmodule als Energieversorgungsmodul ausgebildet sein muss. Gerade bei einem derartigen Energieversorgungsmodul sind dann die oben genannten gegenständlichen Ausgestaltungen besonders vorteilhaft.

Es lässt sich nämlich dann auf diesen einen Schaltungsträger wiederum eine individuelle, mechanisch stabile und bezüglich elektrischer Kennparameter deutlich höher belastbare Kontaktierung zwischen Energieversorgungskontakten und dem Schaltungsträger erreichen.

Vorzugsweise ist der Energieversorgungsanschluss mit den Stanzgitterkontakten direkt an einem die Verkettungskontakte aufnehmenden Schaltungsträger mündend angeordnet und dort verbunden.

Gerade dann, wenn der diesbezügliche Schaltungsträger eine in sich starre ebene Platine ist, kann die mechanische Anbindung des Stanzgitters hochstabil erfolgen und es können andererseits auch hier hohe Ströme beziehungsweise Spannungen an dem Energieversorgungsanschluss gelegt werden und zu diesem Schaltungsträger geleitet werden, ohne dass diesbezüglich Funktionsbeeinträchtigungen oder Beschädigungen dieser genannten Bauteile auftreten würden.

Vorzugsweise sind an dem Energieversorgungsanschluss nach außen mündend mehrere Kontaktstifte angeordnet. Diese Kontaktstifte können an dem Energieversorgungsanschluss durch ein Widerstandsschweißen befestigt sein und mit den Stanzgitterkontakten verbunden sein. Es kann jedoch auch vorgesehen sein, dass diese Kontaktstifte in dem Energieversorgungsanschluss verpresst sind und verlötet sind und dadurch auch eine entsprechende Verbindung mit den Stanzgitterkontakten erzeugt ist. Durch diese Ausgestaltung lässt sich auch der Automatisierungsgrad der Fertigung beziehungsweise Montage des Verkettungsmoduls erhöhen.

Insbesondere ist auch vorgesehen, dass diese Kontaktstifte des Energieversorgungsanschlusses in Öffnungen von Enden der Stanzgitterkontakte durch eine Presspassung eingefügt werden.

In einer weiteren, sehr vorteilhaften Ausführung ist vorgesehen, dass auf einem die Verkettungskontakte aufnehmenden Schaltungsträger auch elektronische Bauteile zur Entstörung der Signalübertragung angeordnet sind. Dies ist dahingehend vorteilhaft, da somit auf einem einzigen Schaltungsträger, der in dem Gehäuse verbaut ist, sowohl alle Verkettungskontakte als auch alle elektronischen Bauteile angeordnet sind. Dadurch werden Signalwege kürzer und die Montage zeitreduziert. Ein wesentlicher Vorteil ist darüber hinaus dahingehend zu sehen, dass keine separate Ausgestaltung eines Schaltungsträgers, der nur die Entstörbauteile aufweist, erforderlich ist. Bei herkömmlichen Ausgestaltungen erfordert ein separater Schaltungsträger mit lediglich den Entstörbauteilen eine sehr aufwendige und gegebenenfalls auch fehleranfällige elektrische Kontaktierung mit weiteren elektrischen Bauteilen in dem Gehäuse und den Verkettungskontakten.

Ein weiterer wesentlicher Vorteil bei diesem Bereitstellen eines Stanzgitters, welches eine elektrische Kontaktierung zwischen den Kontaktstiften des Energieversorgungsanschlusses mit dem Schaltungsträger ermöglicht, ist auch darin zu sehen, dass diese ganzen Stanzgitterkontakte in einem einzigen Stanzgitter beziehungsweise in einem einstückigen Stanzgitter bereitgestellt werden kann und dieses dann einstückige Stanzgitter in seine Endposition im Gehäuse gebracht werden kann. Dies bedeutet, dass dieses Stanzgitter dann auch in sich stabiler ist und in die gewünschte Endposition einfach verbracht werden kann, sodass auch die elektrische Kontaktierung mit dem Schaltungsträger einerseits und den Kontaktstiften des Energieversorgungsanschlusses andererseits verbessert ist. Auch die Montage wird dadurch wesentlich einfacher und schneller.

Erst dann, wenn dieses Stanzgitter seine Einbauposition im Gehäuse erreicht hat und insbesondere erst dann, wenn die mechanische und elektrische Kontaktierung mit dem Schaltungsträger einerseits und den Kontaktstiften andererseits erreicht ist, erfolgt eine Trennung der Stanzgitterkontakte, indem Verbindungsstege des Stanzgitters, mit welchen die Stanzgitterkontakte verbunden sind, getrennt werden. Ein unerwünschtes Verbiegen oder unerwünschte Positionsveränderungen der einzelnen Stanzgitterkontakte kann durch eine derartige Ausgestaltung und Vorgehensweise bei der Montage verhindert werden.

Ein wesentlicher Vorteil einer Ausgestaltung, bei welcher diese Entstörbauteile auf dem Schaltungsträger enthalten sind, auf welchen auch die Verkettungskontakte montiert sind, ist darin zu sehen, dass ein Funktionstest bereits mit der oben erwähnten Einsatzbaugruppe erfolgen kann und somit ein Funktionstest bereits dann erfolgen kann, wenn diese Einsatzbaugruppe noch nicht in dem Gehäuse montiert ist. Dies hat wesentliche Vorteile im Hinblick auf den Ausschuss der Bauteile und insbesondere im Hinblick auf den Umfang von auszusortierenden Verkettungsmodulen. Es muss nämlich dann nicht mehr ein gesamtes Verkettungsmodul ausgesondert werden, sondern gegebenenfalls lediglich und maximal eine derartige Einsatzbaugruppe. Auch dadurch sind wesentlicher Zeitaufwand und insbesondere auch Kosten gespart.

Insbesondere bei einer Ausführung, bei welcher das elektrische Verkettungsmodul ein Verkettungsmodul als solches und kein Energieversorgungsmodul ist, kann der Schaltungsträger auch eine einfache Kunststoffplatte sein.

Wesentliche Vorteile der Erfindung oder einer vorteilhaften Ausführung davon sind auch darin zu sehen, dass eine vormontierte Einsatzbaugruppe, wie sie oben umfänglich erläutert wurde, auch bereits vor dem Verbau in dem Gehäuse auf ihre Funktionsfähigkeit hin überprüft werden kann.

In einer besonders vorteilhaften Ausführung sind die Kontaktierungen zwischen den Verkettungskontakten und dem Schaltungsträger gasdicht ausgebildet. Durch eine derartige Ausgestaltung kann der Übergangswiderstand deutlich reduziert und somit eine höhere Leistungsfähigkeit erreicht werden. Insbesondere können dann elektrische Kennparameter wesentlich verbessert werden. Eine derartige gasdichte Kontaktierung wird insbesondere dadurch erreicht, dass die genannten Kontaktstifte der Verkettungsmodule bezüglich ihrer Geometrie zumindest in einer Raumrichtung geringfügig größer als der Durchmesser von Kontaktlöchern in dem Schaltungsträger sind. Dadurch wird eine Verpressung der Kontaktstifte in die Kontaktlöcher dahingehend erreicht, dass sich diese Kontaktstifte auch in das Material des Schaltungsträgers einarbeiten und eine Lochweitung der Kontaktlöcher auftritt. Die Gasdichtheit ist hier dann besonders hervorzuhebend erreicht.

Insbesondere ist auch vorgesehen, dass das Stanzgitter bei einem Energieversorgungsmodul und somit auch die Stanzgitterkontakte durch eine gasdichte Kontaktierung mit Kontaktlöchern in dem Schaltungsträger verbunden sind.

Gerade durch gasdichte Kontaktierungen kann die Funktionsprüfung der Einsatzbaugruppe, gegebenenfalls bereits durch die Stanzgitter erweitert, umfänglich und aussagekräftig erfolgen. Denn durch die Gasdichtheit ist es quasi auch ausgeschlossen, dass bei der weiteren Handhabung und bei dem weiteren Verbau sich die Kontaktierung durch chemische Prozesse derart verändern, dass sich ein Übergangswiderstand ändern würde und somit das bei der Funktionsprüfung erhaltene Ergebnis verändern würde.

Durch die vorteilhafte Ausführung der Erfindung, bei welcher ein Schaltungsträger als quasi ebene Platte ausgebildet wird und als Basis für alle Verkettungskontakte dient, kann auch dann, wenn vorzugsweise eine Vergussmasse in das Gehäuse eingebracht wird, ein reduzierter Bedarf der Vergussmasse auftreten. Denn durch das Volumen des Schaltungsträgers wird bereits ein gewisser Bauraum im Inneren des Gehäuses eingenommen, der dann nicht mehr mit der Vergussmasse befüllt ist. Durch diese Ausgestaltung mit diesem plattenartigen Schaltungsträger kann auch die Füllhöhe der Vergussmasse reduziert werden, sodass auch in dem Zusammenhang dann Vergussmasse eingespart werden kann. Insbesondere in Verbindung mit den Querstreben und insbesondere mit der Positionierung in der Auflagelänge der Querstreben kann diese Vergussmasse nochmals in ihrer Menge reduziert werden.

Darüber hinaus ist es vorgesehen, dass Kenninformationen des Verkettungsmoduls an eine Außenseite des Gehäuses mittels einer Laserbeschriftung aufgebracht wird. Es kann hier auch ein Data-Matrix-Code aufgebracht werden. Dies ist dahingehend ein wesentlicher Vorteil, dass keine separaten Etiketten vorhanden sind, die sich ablösen können oder die sich entfärben können, sodass die dargestellte Information nicht mehr oder nicht mehr vollständig wahrgenommen werden kann, verhindert werden kann. Durch eine derartige Laserbeschriftung ist die darzustellende Kenninformation dauerhaft aufgebracht und dauerhaft uneingeschränkt wahrnehmbar.

Durch die vorhergehende Bereitstellung einer Einsatzbaugruppe mit dem Schaltungsträger und den bereits in ihren Endlagen montierten Verkettungskontakten können auch nachfolgende Lötoperationen deutlich reduziert werden. Ein weiterer Vorteil ist dann dahingehend zu sehen, dass Waschvorgänge des Moduls, bei welchen Kolophonium der Lötvorgänge abgewaschen werden muss, deutlich reduziert werden kann. Darüber hinaus ist durch diese Vorgehensweise auch die Beschädigung von Komponenten bei der Montage deutlich reduziert, da der Montagevorgang wesentlich einfacher und im Hinblick auf kritische Komponenten und deren Beschädigungen risikoreduzierter ausgebildet ist.

Darüber hinaus entspricht das Verkettungsmodul auch dem ATEX-Standard.

Durch die Erfindung oder einer vorteilhaften Ausgestaltung davon kann der Schaltungsträger mit einer Festigkeit von über 140 g in dem Gehäuse montiert werden.

Bei einer Verkettung von mehreren Verkettungsmodulen, bei welchen dann auch mindestens ein Verkettungsmodul als Energieversorgungsmodul ausgebildet wird, ist eine sogenannte Daisy-Chain realisiert.

Vorzugsweise ist vorgesehen, dass die Stanzgitterkontakte durch Kontaktlöcher in dem Schaltungsträger vollständig sich hindurcherstrecken und dass eine Einführungsphase unter der Oberfläche hervorsteht, sodass damit die Berührungsfläche über die gesamte Bohrungswand eines Kontaktlochs erreicht ist.

Es kann vorgesehen sein, dass der Energieversorgungsanschluss vierpolig oder fünfpolig ausgebildet ist.

Des Weiteren betrifft die Erfindung auch eine Steuerungseinheit für ein pneumatisches Ventilsystem. Die Steuerungseinheit umfasst zumindest ein elektrisches Verkettungsmodul gemäß der Erfindung oder einer vorteilhaften Ausgestaltung davon. Darüber hinaus umfasst die Steuerungseinheit ein separat zum Verkettungsmodul ausgebildetes Funktionsmodul. Das Funktionsmodul ist an der Anbindungsöffnung des Verkettungsmoduls mit dem Verkettungsmodul verbunden und deckt somit die Anbindungsöffnung quasi von oben ab. Elektrische Kontakte des Funktionsmoduls erstrecken sich durch die Anbindungsöffnung des Verkettungsmoduls in das Innere des Gehäuses des Verkettungsmoduls und sind mit den Verkettungskontakten des Verkettungsmoduls verbunden. Insbesondere sind diese elektrischen Kontakte des Funktionsmoduls direkt mit den Verkettungskontakten verbunden.

Ein Funktionsmodul umfasst insbesondere einen externen Anschluss, der ein Sensoranschluss sein kann. In dem Zusammenhang kann somit dann ein Sensor an diese Steuereinheit angeschlossen werden. Darüber hinaus kann an diesen externen Anschluss des Funktionsmoduls auch eine E/A-Baugruppe angeschlossen werden. Ebenfalls kann vorgesehen sein, dass an diesem Anschluss des Funktionsmoduls auch ein Relais angeschlossen ist.

Die elektrischen Kontakte des Funktionsmoduls sind beispielsweise sogenannten CPX-Kontakte. Dieses Funktionsmodul stellt vorzugsweise dann eine Feldbusbaugruppe dar und ist somit mit einer Steuerungsfunktion und/oder einer Schnittstellenfunktion ausgebildet. Ein CPX-Terminal bzw. CPX-Funktionsmodul mit dann derartigen CPX-Kontakten ist insbesondere ein modulares Peripheriesystem für Ventilinseln.

Es kann vorgesehen sein, dass zumindest zehn Verkettungsmodule batterieartig miteinander verbunden sind. Insbesondere können auch zumindest 15 derartige Verkettungsmodule miteinander verbunden sein.

An einer derartigen Steuerungseinheit für ein pneumatisches Ventilsystem sind dann an eine derartige Batterie, die mehrere Verkettungsmodule umfasst, von denen ein Verkettungsmodul ein Energieversorgungsmodul ist, eine Ventilinsel des pneumatischen Ventilsystems angeschlossen.

Ein wesentlicher Gedanke der Erfindung ist darin zu sehen, dass die Verkettungskontakte plattenartig ausgebildet sind und an einem ersten Ende einen glatten Rand aufweisen. Die Verkettungskontakte weisen in ihrer Längsrichtung betrachtet ein dem ersten Ende gegenüberliegendes zweites Ende auf. An diesem zweiten Ende ist eine Mehrzahl von integrierten Kontaktfingern ausgebildet, wobei an diesem zweiten Ende zumindest sieben separate Kontaktfinger ausgebildet sind.

Vorzugsweise ist vorgesehen, dass sich die Verkettungskontakte jeweils über die gesamte Breite des Gehäuses erstrecken und sich durch zumindest einen ersten Durchführungsschlitz bzw. eine Durchführungsöffnung in der ersten Seitenwand aus dem Gehäuse nach außen erstrecken und sich durch zumindest eine zweite Durchführungsöffnung an einer der ersten Seitenwand gegenüberliegenden zweiten Seitenwand des Gehäuses aus dem Gehäuse nach außen erstrecken.

In einer vorteilhaften Ausführung ist vorgesehen, dass jeder Kontaktfinger eine endseitige Aufbiegung aufweist. Dadurch kann ein Verklemmen und ein Verspreizen bei dem Verbinden mit einem Verkettungskontakt eines anderen Verkettungsmoduls vermieden werden. Darüber hinaus legen sich diese Kontaktfinger mit den jeweils in einer Reihe der Kontaktfinger betrachtet alternierend in jeweils gegenüberliegende Richtungen sich aufbiegende Bereiche an gegenüberliegenden Seiten eines als Schwertkontaktbereich ausgebildeten glatten Rands eines Verkettungskontakts eines anderen Verkettungsmoduls an. Dadurch ist somit quasi eine beidseitige Klammerung der Kontaktfinger dieses glatten Rands des Schwertkontaktbereichs des anderen Verkettungskontakts eines anderen Verkettungsmoduls gegeben. Dieser glatte Bereich des anderen Verkettungskontakts ist somit ineinandergeschoben beziehungsweise verzahnt mit diesen Kontaktfingern angeordnet.

Bei einer vorteilhaften Ausführung ist vorgesehen, dass die Kontaktfinger als Stanzkontakte in einem Verkettungskontakt ausgebildet sind. Insbesondere sind dann genau sieben Kontaktfinger ausgebildet.

Die Kontaktfinger können auch als lasergeschnittene Kontaktfinger ausgebildet sein.

Bei einer weiteren vorteilhaften Ausführung ist vorgesehen, dass bei einer gleichen Bauhöhe des Verkettungskontakts und somit auch einer gleichen Bauhöhe der in Reihe zueinander angeordneten Kontaktfinger acht Kontaktfinger integriert ausgebildet sind, die dann als lasergeschnittene Kontakte in dem Verkettungskontakt erzeugt sind. Da durch eine Laserbearbeitung die Geometriepräzision beziehungsweise die Materialabtragungstoleranz kleiner ist als beim Stanzen, kann mit dieser Vorgehensweise die Anzahl der Kontaktfinger sogar noch erhöht werden. Durch eine derartige Ausgestaltung lassen sich dann durch die ansonsten gleichen Geometrien des Verkettungskontakts die bereits oben genannten elektrischen Kennparameter des Verkettungsmoduls, insbesondere im Hinblick auf die Übertragung von höheren Strömen sowie die bessere Stromsicherheit, verbessern.

In einer besonders vorteilhaften Ausführung ist vorgesehen, dass eine in Richtung der anderen Kontaktfinger bemessene Höhe eines Kontaktfingers, insbesondere jeweils aller Kontaktfinger, kleiner ist als ein in diese Höhenrichtung bemessener Abstand zwischen zwei benachbarten Kontaktfingern. Es ist somit vorteilhaft vorgesehen, dass ein Freiraum zwischen einer Unterkante beziehungsweise einem unteren Rand eines ersten Kontaktfingers zu einem oberen Rand beziehungsweise einer oberen Kante eines dazu benachbarten Kontaktfingers größer ist als eine in diese Höhenrichtung bemessene Höhe eines Kontaktfingers und somit die Höhe zwischen einem unteren Rand und einem oberen Rand dieses Kontaktfingers. Dies gilt insbesondere für alle Kontaktfinger eines Verkettungskontakts. Gerade durch diese Ausgestaltung kann dann erreicht werden, dass die Anzahl der Kontaktfinger maximiert wird und insbesondere zumindest sieben Kontaktfinger ausgebildet werden können und dennoch die Gesamthöhe des Verkettungskontakts sich nicht verändert. Bei gleicher Bauhöhe im Vergleich zu herkömmlichen Ausgestaltungen kann somit eine sehr hohe Anzahl an Kontaktfingern realisiert werden, die die oben genannten elektrischen Kenngrößen beziehungsweise Kennparameter des Verkettungsmoduls deutlich verbessert und andererseits auch die Steckkraft dennoch reduziert. Die Funktionalität und die Einsatztauglichkeit eines gesamten Verkettungsmoduls sind dadurch wesentlich verbessert.

Weitere Merkmale der Erfindung ergeben sich aus den Ansprüchen, den Figuren und der Figurenbeschreibung.

Ausführungsbeispiele der Erfindung werden nachfolgend anhand schematischer Zeichnungen näher erläutert. Es zeigen:
- Fig. 1: eine Explosionsdarstellung eines Ausführungsbeispiels einer erfindungsgemäßen Steuereinheit für ein pneumatisches Ventilsystem;
- Fig. 2: die Steuereinheit gemäß Fig. 1 im zusammengesetzten Zustand;
- Fig. 3: eine perspektivische Darstellung der Batterie mit drei Steuereinheiten, die miteinander verkettet sind, wobei eine davon gemäß der Darstellung in Fig. 2 ausgebildet ist;
- Fig. 4: eine erste perspektivische Darstellung des als Energieversorgungsmodul ausgebildeten Verkettungsmoduls, wie es dann bei einer Steuereinheit gemäß Fig. 2 und Fig. 3 verbaut ist;
- Fig. 5: eine zu Fig. 4 unterschiedliche perspektivische Darstellung des Energieversorgungsmoduls;
- Fig. 6: das Energieversorgungsmodul gemäß Fig. 4 und Fig. 5 mit bereits eingesetzter Einsatzbaugruppe, die einen Schaltungsträger und Verkettungskontakte aufweist;
- Fig. 7: eine zu Fig. 6 unterschiedliche perspektivische Darstellung eines Energieversorgungsmoduls gemäß Fig. 6;
- Fig. 8: ein Ausführungsbeispiel eines Schaltungsträgers, wie er in dem Energieversorgungsmodul gemäß Fig. 6 und Fig. 7 verbaut ist;
- Fig. 9: eine perspektivische Darstellung eines Ausführungsbeispiels eines Verkettungskontakts;
- Fig. 10: eine vergrößerte Darstellung eines Teilbereichs des Verkettungskontakts gemäß Fig. 9;
- Fig. 11: eine perspektivische Darstellung einer vormontierten Einsatzbaugruppe von oben;
- Fig. 12: eine perspektivische Darstellung der Einsatzbaugruppe gemäß Fig. 11 von unten betrachtet;
- Fig. 13: eine perspektivische Darstellung eines spezifischen Montagezustands des Energieversorgungsmoduls;
- Fig. 14: eine Vertikalschnittdarstellung des Energieversorgungsmoduls gemäß Fig. 13;
- Fig. 15: eine perspektivische Darstellung des Energieversorgungsmoduls in einem zu Fig. 13 und Fig. 14 nachfolgenden spezifischen Montagezustand;
- Fig. 16: das Energieversorgungsmodul gemäß Fig. 15 in einer Vertikalschnittsdarstellung;
- Fig. 17: eine perspektivische Darstellung des Energieversorgungsmoduls in einem zu Fig. 15 und Fig. 16 weiteren spezifischen Montagezustand mit einer Zwischenlage beziehungsweise Zwischenmontageposition der Einsatzbaugruppe;
- Fig. 18: eine Vertikalschnittdarstellung des Energieversorgungsmoduls gemäß Fig. 17;
- Fig. 19: eine perspektivische Darstellung des Energieversorgungsmoduls in einem zu Fig. 17 und 18 nachfolgenden spezifischen Montagezustand, bei welchem die Einsatzbaugruppe in ihrer Endposition in einem Gehäuse des Energieversorgungsmoduls angeordnet ist;
- Fig. 20: eine Draufsicht von oben auf das Energieversorgungsmodul gemäß Fig. 19;
- Fig. 21: eine perspektivische Darstellung eines Teilausschnitts des Energieversorgungsmoduls gemäß Fig. 19 und 20 in einem nachfolgenden Montagezustand, in welchem ein Stanzgitter mit Stanzgitterkontakten eingebracht ist;
- Fig. 22: eine perspektivische Darstellung eines Teilausschnitts des Energieversorgungsmoduls in einem weiteren Montagezustand, in dem Kontaktstifte eines Energieversorgungsanschlusses des Energieversorgungsmoduls verbaut sind;
- Fig. 23: eine perspektivische Ansicht in das Innere des Gehäuses des Energieversorgungsmoduls im Montagezustand gemäß Fig. 22;
- Fig. 24: eine perspektivische Schnittdarstellung durch das Energieversorgungsmodul gemäß Fig. 22 und 23; und
- Fig. 25: eine vergrößerte Darstellung eines Teilausschnitts des Energieversorgungsmoduls im Bereich von zweiten Aufnahmeschlitzen und mit zumindest sieben Kontaktfingern ausgebildeten zweiten Enden der Verkettungskontakte, die sich durch die zweiten Aufnahmeschlitze und eine zweite Durchführungsöffnung am Gehäuse nach außen erstrecken und in ihrer Endlage angeordnet sind.

In den Figuren werden gleiche oder funktionsgleiche Elemente mit den gleichen Bezugszeichen versehen.

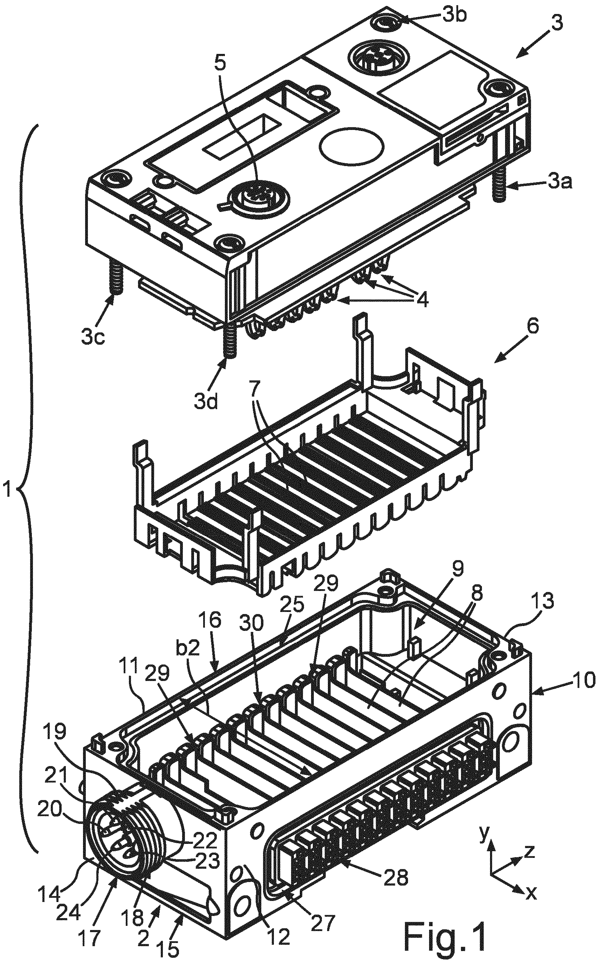

In Fig. 1 ist in einer Explosionsdarstellung eine Steuereinheit 1 für ein pneumatisches Ventilsystem gezeigt. Dieses Ausführungsbeispiel einer erfindungsgemäßen Steuereinheit 1 ist zur Steuerung dieses Ventilsystems, welches in einer Produktionsanlage in der Automatisierungstechnik oder einer Produktionsanlage in der Schweißtechnik oder einer Produktionsanlage in der Automobiltechnik angeordnet ist, zur Übermittlung serieller Signale zu und/oder von in einer Reihe angeordneten elektrischen Verbrauchern, insbesondere Ventilen des pneumatischen Ventilsystems ausgebildet.

Diese Steuereinheit 1 umfasst ein elektrisches Verkettungsmodul , welches in der gezeigten Ausführung in Fig. 1 als Energieversorgungsmodul 2 ausgebildet ist. Darüber hinaus umfasst die Steuereinheit 1 auch ein Funktionsmodul 3, welches separat zum Energieversorgungsmodul 2 ausgebildet ist und mit diesem zur Funktionalität der Steuereinheit 1 verbunden werden kann.

Das Funktionsmodul 3 weist eine Mehrzahl von elektrischen Kontakten 4 auf, die beispielsweise CPX-Kontakte sein können. Das Funktionsmodul 3 ist eine Feldbusbaugruppe, welche Steuerungsfunktionen und/oder Schnittstellenfunktionen bereitstellt. Das Funktionsmodul 3 umfasst zumindest einen Anschluss 5, an dem ein Sensor oder ein Relais oder eine E/A-Baugruppe angeschlossen werden kann.

Darüber hinaus umfasst im Ausführungsbeispiel die Steuereinheit 1 eine separate Abdeckung 6, die im montierten Zustand zwischen dem Funktionsmodul 3 und dem Energieversorgungsmodul 2 angeordnet ist und durch welche die Komponenten des Funktionsmoduls 3 von den Komponenten des Energieversorgungsmoduls 2 separiert ist. Die Abdeckung 6 ist insbesondere aus Kunststoff und einstückig hergestellt. Die Abdeckung 6 umfasst jedoch eine Mehrzahl von Öffnungen 7, durch welche sich Verkettungskontakte 8, von denen in Fig. 1 nur einige, der Übersichtlichkeit dienend, mit einem Bezugszeichen versehen sind, hindurcherstrecken können und direkt dann mit den elektrischen Kontakten 4 verbunden werden können.

Die Verkettungskontakte 8 sind Bestandteil des Energieversorgungsmoduls 2 und dort in einem Inneren 9 eines Gehäuses 10 angeordnet. Das Gehäuse 10 ist eckig, insbesondere rechteckig, ausgebildet und kann abhängig vom Einsatzgebiet der Steuerungseinheit 1 aus Metall oder auch Kunststoff sein.

Das Gehäuse 10 umfasst eine erste Seitenwand 11 und eine dieser gegenüberliegende und parallel dazu orientierte zweite Seitenwand 12. Diese beiden Seitenwände 11 und 12 sind mit einer dritten Seitenwand 13, die eine Hinterwand darstellt, und einer vierten Seitenwand 14, die eine Vorderwand darstellt, miteinander verbunden.

Darüber hinaus umfasst das Gehäuse 10 einen Boden 15, durch welchen das Gehäuse 10 nach unten hin vollständig abgedeckt ist.

Dem Boden 15 gegenüberliegend ist das Gehäuse 10 vollständig offen ausgebildet und weist in dem Zusammenhang eine Anbindungsöffnung 16 auf. Durch diese Anbindungsöffnung 16 ist das Innere 9 vollständig und frei zugänglich. Über die Anbindungsöffnung 16 wird das Funktionsmodul 3 an dem Energieversorgungsmodul 2 angebunden beziehungsweise daran befestigt. Die Anbindungsöffnung 16 ist dann im montierten Endzustand der Steuereinheit 1 durch das Funktionsmodul 3 vollständig abgedeckt.

In der gezeigten Ausführung des Energieversorgungsmoduls 2 weist dieses einen Energieversorgungsanschluss 17 auf, der im Ausführungsbeispiel an der vierten Seitenwand 14 und somit an der Vorderwand ausgebildet ist. Der Energieversorgungsanschluss 17 ist zur externen Kopplung einer Energieversorgungsquelle und somit zur Übertragung von Energie an das Energieversorgungsmodul 2 ausgebildet. Dazu umfasst der Energieversorgungsanschluss 17 einen Koppelflansch 18, an dem ein Außengewinde 19 ausgebildet ist. Dadurch kann auch ein mechanischer Anschluss der externen Energieversorgungsquelle erfolgen.

Innerhalb des hohlzylinderförmigen Flansches 18 erstrecken sich im Ausführungsbeispiel fünf Kontaktstifte als Energieversorgungskontakte 20, 21, 22, 23 und 24. In dem Ausführungsbeispiel ist somit dieser Energieversorgungsanschluss 17 fünfpolig ausgebildet. Er kann auch alternativ vierpolig ausgebildet sein.

Darüber hinaus umfasst das Energieversorgungsmodul 2 eine Trägervorrichtung 25, die zur Aufnahme der Verkettungskontakte 8 ausgebildet ist. Insbesondere ist vorgesehen, dass die Trägervorrichtung 25 zur Aufnahme einer vormontierten Einsatzbaugruppe ausgebildet, die die Verkettungskontakte 8 und einen Schaltungsträger aufweist, an dem die Verkettungskontakte angeordnet sind.

Die Trägervorrichtung 25 umfasst mehrere Trägerbereiche beziehungsweise Trägerelemente.

Im Ausführungsbeispiel ist die Trägervorrichtung 25 einstückig aus Kunststoff ausgebildet und umfasst eine Wanne, die als Einsatz in das Gehäuse 10 ausgebildet ist und dort positionsfixiert angeordnet ist. Die Trägervorrichtung 25 kann in dem Zusammenhang als einstückiges Spritzgussbauteil ausgebildet sein.

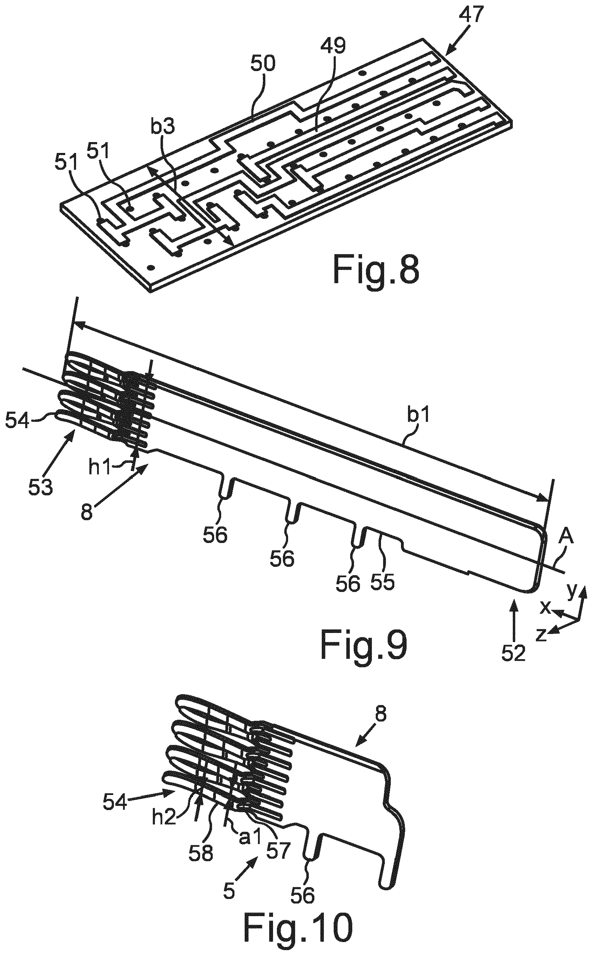

Wie zu erkennen ist, erstrecken sich mehrere Verkettungskontakte 8, die jeweils einstückig ausgebildet sind, als plattenartige Elemente beziehungsweise als Streifenelemente über die gesamte Breite (Erstreckung in x-Richtung) des Gehäuses 10. Sie weisen in dem Zusammenhang eine Breite b1 (Fig. 8) auf, die größer als eine Breite b2 des Gehäuses 10, insbesondere des Inneren 9 des Gehäuses 10, ist. Die Breite b1 eines Verkettungskontakts 8 bemisst sich dabei entlang der Längsachse A dieses Verkettungskontakts 8.

Die Verkettungskontakte 8 erstrecken sich somit auch außerhalb des Gehäuses 10 in dieser Breitenrichtung und somit in x-Richtung betrachtet.

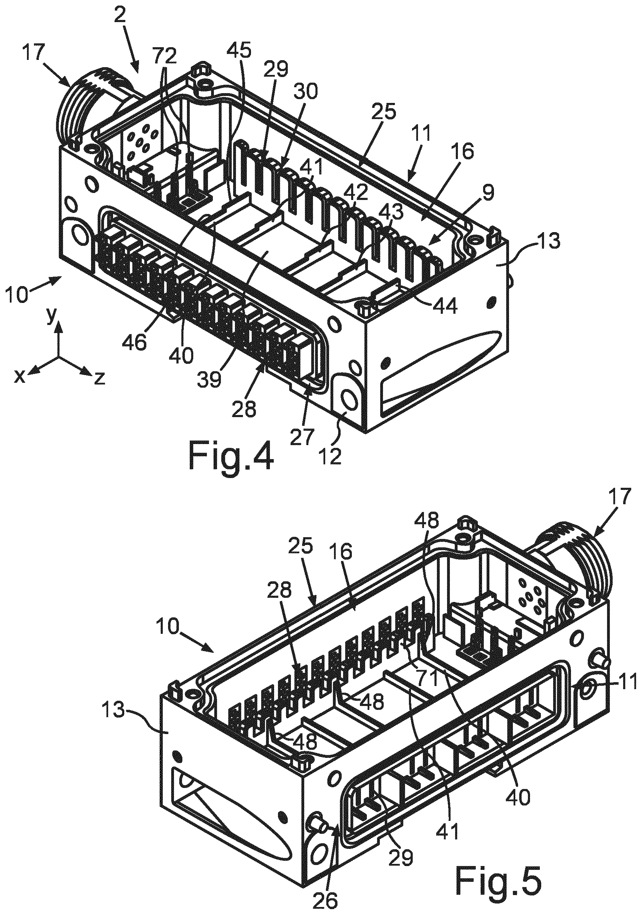

Dazu weist das Gehäuse 10 an seiner ersten Seitenwand 11 eine erste Durchführungsöffnung 26 (Fig. 5) bzw. einen Durchführungsschlitz auf. Diese erste Durchführungsöffnung 26 erstreckt sich in Höhenrichtung und somit in y-Richtung. Sie sind in dieser Höhenrichtung sowohl an ihrem unteren Ende, welches dem Boden 15 zugewandt ist, als auch an ihrem oberen Ende, welches der Anbindungsöffnung 16 zugewandt ist, geschlossen. Die erste Durchführungsöffnung 26 ist daher umlaufend geschlossen begrenzt. Es können auch mehrere separate erste Durchführungsöffnungen 26 an der Seitenwand 11 ausgebildet sein.

Wie in dem Ausführungsbeispiel in Fig. 5 zu erkennen ist, ist an dieser ersten Seitenwand 11 des Energieversorgungsmoduls 2 lediglich ein einziger erster Durchführungsschlitz 26 ausgebildet, der als längliche Durchbrechung ausgebildet ist. Durch diese erstreckt sich die Trägervorrichtung 25 in ihrer wannenartigen Ausgestaltung hinein und auch geringfügig nach außen.

Wie darüber hinaus in Fig. 1 zu erkennen ist, umfasst das Gehäuse 10 an der zweiten Seitenwand 12 im Ausführungsbeispiel ebenfalls nur einen einzigen zweiten Durchführungsschlitz bzw. eine zweite Durchführungsöffnung 27. Es kann auch hier vorgesehen sein, dass mehrere parallel zueinander orientierte und in Höhenrichtung ausgerichtete zweite Durchführungsschlitze in der Seitenwand 12 ausgebildet sind.

Bei dem Ausführungsbeispiel gemäß Fig. 1 ist vorgesehen, dass sich diese Trägervorrichtung 25 dann durch diese randseitige längliche Durchführöffnung 27 in der Seitenwand 12 hinaus erstreckt.

Entsprechend ist auch gemäß der Darstellung in Fig. 5 eine erste Durchführöffnung 26 ausgebildet, durch welche sich die Trägervorrichtung 25 mit integrierten ersten Aufnahmeschlitzen 29 erstreckt.

In dem in Fig. 1 gezeigten montierten Endzustand des Energieversorgungsmoduls 2 erstrecken sich somit die Verkettungskontakte 8 jeweils in ihrer einstückigen Ausgestaltung über die gesamte Breite b2 und darüber hinaus auch in die erste Durchführungsöffnung 26 und die zweite Durchführungsöffnung 27 hinein, sodass sie sich auch diesbezüglich aus dem Gehäuse 10 über die Seitenwand 11 hinaus und auch über die zweite Seitenwand 12 hinaus erstrecken.

Wie darüber hinaus in Fig. 1 auch zu erkennen ist, sind benachbart zu dieser ersten Seitenwand 11 in die Trägervorrichtung 25 integriert erste Aufnahmeschlitze 29 ausgebildet, welche in Höhenrichtung und somit in y-Richtung orientiert sind. Diese Aufnahmeschlitze 29 sind somit weiter innen und somit zum Inneren 9 hin ausgebildet als die erste Durchführöffnung 26.

Wie zu erkennen ist, sind die Aufnahmeschlitze 29 an ihrem der Anbindungsöffnung 16 zugewandten oberen Ende 30 offen ausgebildet. Dies bedeutet, dass sie bezüglich ihrer Dimensionierung nach oben hin nicht begrenzt sind und somit ein erster Aufnahmeschlitz 29 nur durch eine U-artige Begrenzungskontur begrenzt ist.

Ein Verkettungskontakt 8 kann somit über die Anbindungsöffnung 16 von oben eingeführt werden und auch über dieses obere Ende 30, welches offen ausgebildet ist, in den ersten Aufnahmeschlitz 29 eingefädelt werden.

Der Übersichtlichkeit dienend sind in Fig. 1 nur einige der parallel zueinander orientierten ersten Aufnahmeschlitze 29 mit einem Bezugszeichen versehen.

Wie in Fig. 1 gezeigt ist, wird durch diese ersten Aufnahmeschlitze 29 auch eine seitliche Stabilisierung der Verkettungskontakte 8 in ihrer Endposition erreicht.

Die Verkettungskontakte 8 sind vertikal orientiert und erstrecken sich somit jeweils in einer Ebene, die durch die Höhenrichtung und die Breitenrichtung aufgespannt ist.

Die ersten Aufnahmeschlitze 29 sind in ihrer Erstreckung in Höhenrichtung geradlinig ausgebildet. Sie sind zum Hindurcherstrecken und Führen jeweils eines Verkettungskontakts 8 ausgebildet.

Die ersten Aufnahmeschlitze 29 erstrecken sich, wie dies in Fig. 1 zu erkennen ist, in Höhenrichtung weiter nach oben, als eine in y-Richtung bemessene Höhe eines Verkettungskontakts 8 beträgt. Die Verkettungskontakte 8 tauchen somit über ihre gesamte Höhe in einen ersten Aufnahmeschlitz 29 ein.

Im gezeigten Ausführungsbeispiel ist vorgesehen, dass das Funktionsmodul 3 durch eine zerstörungsfrei lösbare Verbindung, insbesondere eine Schraubverbindung, mit beispielhaft vier Schrauben 3a, 3b, 3c und 3d an dem Energieversorgungsmodul 2 im Bereich der Anbringungsöffnung 16 angeschraubt werden kann.

Vorzugsweise ist zwischen dem Energieversorgungsmodul 2 und dem Funktionsmodul 3 ein Dichtelement angeordnet.

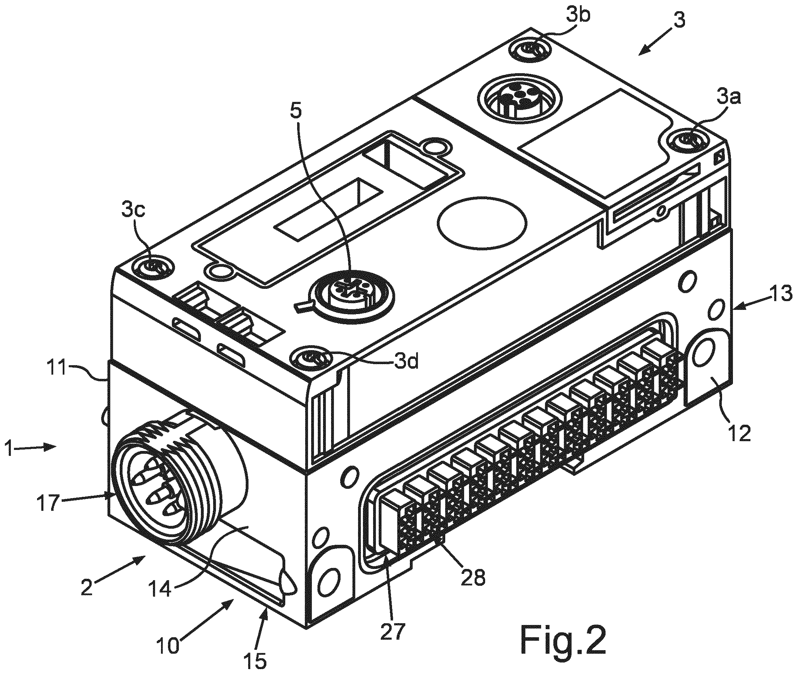

In Fig. 2 ist eine perspektivische Darstellung eines zusammengesetzten Zustands der Steuerungseinheit 1 gezeigt. Wie zu erkennen ist, ist das Funktionsmodul 3 in der Größe an die Größe des Gehäuses 10 des Energieversorgungsmoduls 2 angepasst, sodass hier ein quaderförmiger Block entsteht.

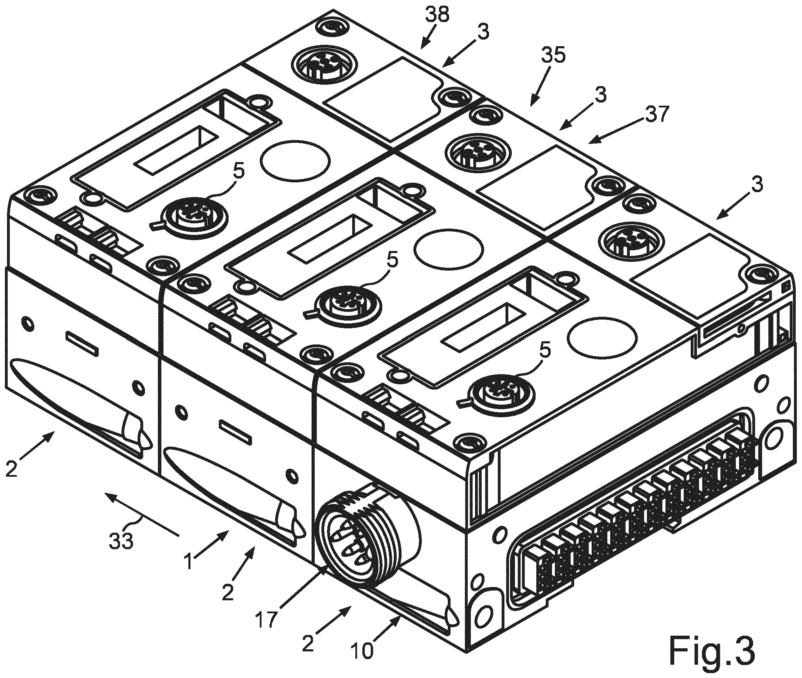

In Fig. 3 ist in einer perspektivischen Darstellung eine Modul-Batterie für ein pneumatisches Ventilsystem gezeigt, bei welchem der Verkettungsstrang 35 gezeigt ist. Hier ist in einer Verkettungsrichtung 36 ein als Energieversorgungsmodul 2 ausgebildetes elektrisches Verkettungsmodul mit zwei als Nichtenergieversorgungsmodule ausgebildete elektrische Verkettungsmodule 37 und 38 verkettet. Es kann vorgesehen sein, dass die jeweiligen Funktionsmodule 3 baugleich sind, insbesondere auch funktionsgleich ausgebildet sind. Sie können jedoch auch unterschiedlich ausgestaltet sein.

In Fig. 4 ist in einer perspektivischen Darstellung das Gehäuse 10 des Energieversorgungsmoduls gezeigt, wobei hier die Trägervorrichtung 25 ebenfalls dargestellt ist. Bei dieser Ausführung sind an einem Boden 39 der Trägervorrichtung 25 integriert eine Mehrzahl von Querstreben 40, 41, 42, 43 und 44 ausgebildet. Diese Querstreben 40 bis 44 erstrecken sich in Breitenrichtung des Gehäuses 10 geradlinig und sind an gegenüberliegenden Seitenwänden der Trägervorrichtung 25 mündend.

Die Querstreben 40 bis 44 sind im Ausführungsbeispiel gleich ausgebildet, sodass die weitere Erläuterung lediglich anhand der Querstrebe 40 erfolgt. Die Querstrebe 40 erhebt sich erhaben ausgehend von dem Boden 39 nach oben in Richtung der Anbindungsöffnung 16. Die Querstrebe 40 umfasst darüber hinaus eine erste Erhöhung 45, die sich entlang eines oberen Rands der Querstrebe 40 erstreckt. Die erste Erhöhung 45 ist somit erhaben in Richtung der Anbindungsöffnung 16 ausgebildet. Sie mündet an diejenige Seitenwand der Trägervorrichtung 25, an der die ersten Aufnahmeschlitze 29 ausgebildet sind. Die erste Erhöhung 45 erstreckt sich nur bereichsweise über die in Breitenrichtung bemessene Länge der Querstrebe 40. Dadurch ist die Querstrebe 40 an ihrer der Anbindungsöffnung 16 zugewandten Seite gestuft ausgebildet.

Durch die erste Erhöhung 45 ist eine Auflagelänge 46 des oberen Rands, der der Anbindungsöffnung 16 zugewandt ist, der Querstrebe 40 begrenzt. Diese Auflagelänge 46 ist größer als eine Breite eines Schaltungsträgers 47 (Fig. 8), der eine ebene und in sich starre Platine darstellt. Im montierten Zustand des Schaltungsträgers 47 in dem Inneren 9 des Gehäuses 10 ist die Breite b3 des Schaltungsträgers 47 in x-Richtung orientiert. Diese Auflagelänge 46 ist größer, jedoch vorzugsweise maximal nur 1 Prozent größer als diese Breite b3.

In der Endposition des Schaltungsträgers 47 in dem Gehäuse 10 liegt der Schaltungsträger 47 lediglich auf der Auflagelänge 46 der Querstrebe 40 auf und ist dadurch relativ positionssicher gehalten, durch die entsprechende Größe der Ausgestaltung der Auflagelänge 46 im gewissen Maße auch und begrenzt schwimmend darin gelagert.

Die erste Erhöhung 45 weist in y-Richtung und somit in Höhenrichtung eine Höhe auf, die niedriger ist als eine in Fig. 5 zu erkennende zweite Erhöhung 48, die sich ebenfalls an der Querstrebe 40 erhaben nach oben erstreckt. Diese zweite Erhöhung 48 begrenzt an der gegenüberliegenden Seite die Auflagelänge 46. Diese zweite Erhöhung 48 ist zur Anbindungsöffnung 16 hin höher ausgebildet als die erste Erhöhung 45. Dadurch ergeben sich Montagevorteile, und ein Hinwegrutschen des Schaltungsträgers 47 über die zweite Erhöhung 48 beim Verbringen des Schaltungsträgers 47 in die Endposition ist verhindert. Dadurch kann dann auch ein zu weites nach außen Schieben der Verkettungskontakte 8 in die zweite Durchführungsöffnung 27 verhindert werden. die zweite Erhöhung 48 ist an einem in das Innere 9 ragenden Überstand 71 ausgebildet.

Die Trägervorrichtung 25 umfasst darüber hinaus auch zweite Aufnahmeschlitze 28, wie sie in Fig. 5 zu erkennen sind, wobei hier ebenfalls der Übersichtlichkeit dienend nur ein zweiter Aufnahmeschlitz 28 mit den entsprechenden Bezugszeichen versehen ist.

Die zweiten Aufnahmeschlitze 28 erstrecken sich ebenfalls in Höhenrichtung und sind sowohl an ihrem oberen als auch an ihrem unteren Ende geschlossen. Ein Einfädeln, wie es bei dem ersten Aufnahmeschlitz 29 ermöglicht ist, ist daher bei dem zweiten Aufnahmeschlitz 28 nicht möglich.

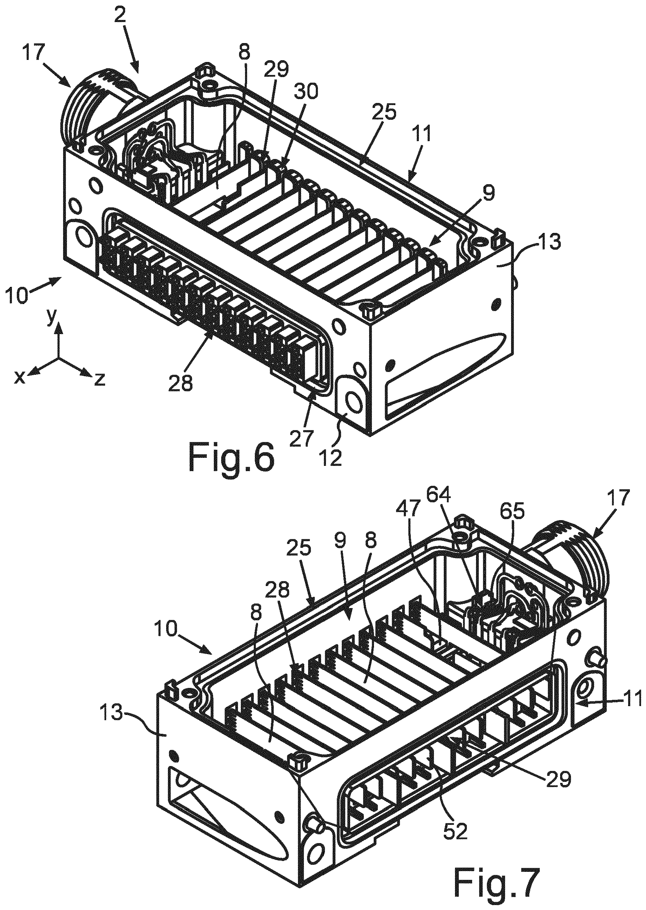

In Fig. 6 und 7 ist in verschiedenen Perspektiven das Energieversorgungsmodul 2 im montierten Endzustand gezeigt.

In Fig. 8 ist ein Ausführungsbeispiel eines Schaltungsträgers 47 gezeigt, der als rechteckige, in sich starre Platine ausgebildet ist. Auf dem Schaltungsträger sind beispielhaft Leiterbahnen 49, 50 (nur einige sind mit Bezugszeichen versehen) ausgebildet und darüber hinaus auch noch Kontaktlöcher 51 erzeugt, von denen ebenfalls der Übersichtlichkeit dienend nur einige mit den Bezugszeichen versehen sind.

In Fig. 9 ist in einer perspektivischen Darstellung ein Ausführungsbeispiel eines Verkettungskontakts 8 gezeigt, der einstückig ausgebildet ist. Der Verkettungskontakt 8 weist ein in Richtung seiner Längsachse A betrachtet erstes Ende 52 auf. Dieses erste Ende 52 ist mit einem glatten Rand ausgebildet und stellt somit insbesondere einen Schwertkontaktbereich dar. An einem gegenüberliegenden zweiten Ende 53 weist dieser Verkettungskontakt 8 eine Mehrzahl von Kontaktfingern, insbesondere zumindest sieben Kontaktfinger, 54 auf. Diese Kontaktfinger 54 sind separat und in Höhenrichtung des Verkettungskontakts 8 in Reihe zueinander angeordnet.

In Höhenrichtung des Verkettungskontakts betrachtet und somit in Richtung der Reihe, in der die zumindest sieben Kontaktfinger 54 beabstandet zueinander angeordnet sind, weist der Verkettungskontakt 8 eine Höhe auf, die insbesondere zwischen 0,85 cm und 0,95 cm beträgt.

Darüber hinaus sind an dem Verkettungskontakt 8 an einem unteren schmalen Rand 55 mehrere, im Ausführungsbeispiel drei, Kontaktstifte 56 ausgebildet. Diese Kontaktstifte 56 werden bei der Montage des Verkettungskontakts 8 an den Schaltungsträger 47 in entsprechend vorgesehene Kontaktlöcher 51 verbracht. Insbesondere ist hier ein Verpressen vorgesehen, wobei dies vorzugsweise derart erfolgt, dass eine gasdichte Kontaktierung ausgebildet ist. Im montierten Zustand ist dann der Verkettungskontakt 8, der sich im Wesentlichen in einer Ebene erstreckt, senkrecht stehend auf der Ebene, in der sich der Schaltungsträger 47 erstreckt, angeordnet.

Die Breite b1 des Verkettungskontakts 8 ist größer als die Breite b3 des Schaltungsträgers 47.

In Fig. 10 ist in einer vergrößerten Darstellung das zweite Ende 53 des Verkettungskontakts 8 dargestellt. Die sieben Kontaktfinger 54 sind zu erkennen. Wie gezeigt ist, umfasst jeder Kontaktfinger 54 einen Haltesteg 57, der sich aus der Ebene, in der sich der restliche Verkettungskontakt 8 mit seinem plattenartigen Bereich erstreckt, herausragt. An diesen Steg 57 angrenzend ist ein laschenartiger Bereich 58 ausgebildet, der somit bereichsweise, insbesondere an seinem vorderen freien Ende, gekrümmt ist. Es ist insbesondere vorgesehen, dass in Höhenrichtung und somit in y-Richtung die Kontaktfinger 54 beabstandet zueinander angeordnet sind und jeweils alternierend zu unterschiedlichen Seiten des plattenartigen Bereichs des Verkettungskontakts 8 hin orientierte Stege 57 und dann auch in unterschiedliche Richtungen und somit alternierend gebogene laschenartige Bereiche 58 ausgebildet sind.

In einer vorteilhaften Ausführung ist vorgesehen, dass die in den Verkettungskontakt 8 integrierten Kontaktfinger 54 als Stanzkontakte ausgebildet sind. Insbesondere sind sie dann genau sieben Kontaktfinger 54. Es kann auch vorgesehen sein, dass die Anzahl der Kontaktfinger 54 größer ist und insbesondere acht Kontaktfinger 54 ausgebildet sind. Diese sind dann vorzugsweise als lasergeschnittene Kontaktfinger ausgebildet. Unabhängig davon, ob sieben oder acht Kontaktfinger 54 ausgebildet sind, ist eine Höhe h1 immer gleich.

Insbesondere ist vorgesehen, dass eine in Richtung der anderen Kontaktfinger 54 bemessene Höhe h2 (Fig. 10) eines Kontaktfingers kleiner ist als ein in diese Höhenrichtung bemessener Abstand a1 zwischen zwei benachbarten Kontaktfingern 54. Insbesondere bemisst sich dieser Abstand a1 zwischen einer Oberkante beziehungsweise einem oberen Rand eines ersten Kontaktfingers 54 und einem unteren Rand eines dazu benachbarten weiteren Kontaktfingers 54. Diese Dimensionierungen der Höhe h2 und des Abstands a1 gilt für alle Kontaktfinger 54.

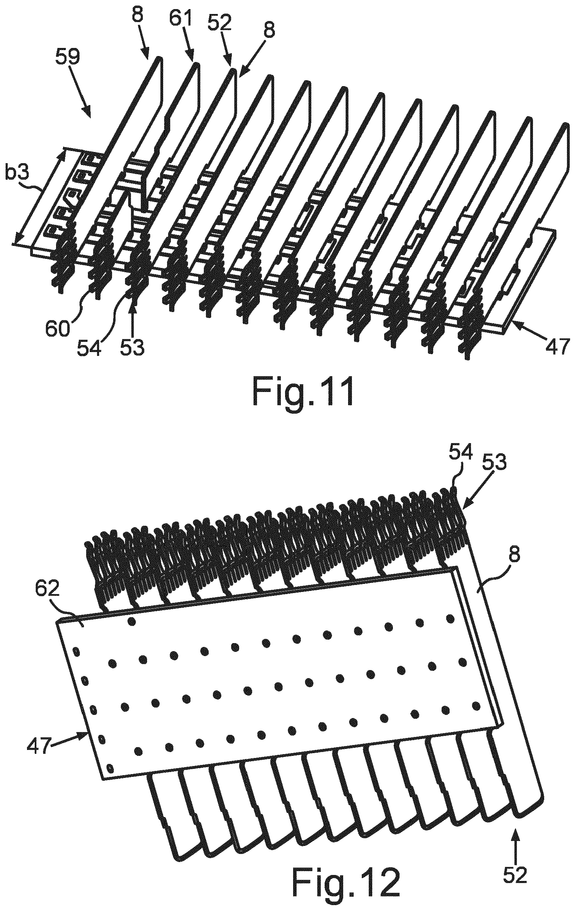

In Fig. 11 ist in einer perspektivischen Darstellung ein Ausführungsbeispiel einer vormontierten Einsatzbaugruppe 59 gezeigt. Diese vormontierte Einsatzbaugruppe umfasst den Schaltungsträger 47 und die Mehrzahl von darauf in ihrer Endposition montierten und parallel und beabstandet zueinander angeordneten Verkettungskontakten 8. Auf den Schaltungsträger 47 sind auch zwei weitere elektrische Kontakte 60 und 61 angeordnet, die als Daisy-Chain-Kontakte ausgebildet sind und entsprechende Abnahmekontakte darstellen.

Insbesondere ist es vorgesehen, dass die Verkettungskontakte 8 nicht nur mit ihren Kontaktstiften 56 in die Kontaktlöcher 51 verpresst werden, sondern auch dann noch diesbezüglich daran verlötet werden. Diese vormontierte Einsatzbaugruppe 59 ist in Fig. 12 in einer perspektivischen Darstellung von unten gezeigt. Es ist zu erkennen, dass sich die Kontaktstifte 56 aus den Kontaktlöchern erhaben nach unten über eine Unterseite 62 des Schaltungsträgers 47 herauserstrecken.

Bei der Montage ist vorgesehen, dass die Verkettungskontakte 8 zunächst mit einer geeigneten Vorrichtung zueinander platziert werden und dann der Schaltungsträger 47 darauf positioniert wird. Anschließend werden dann die Verkettungskontakte 8 eingepresst. Die Kontaktstifte 56 stehen mit einer Einführungsphase über diese Unterseite 62 nach unten erhaben über.

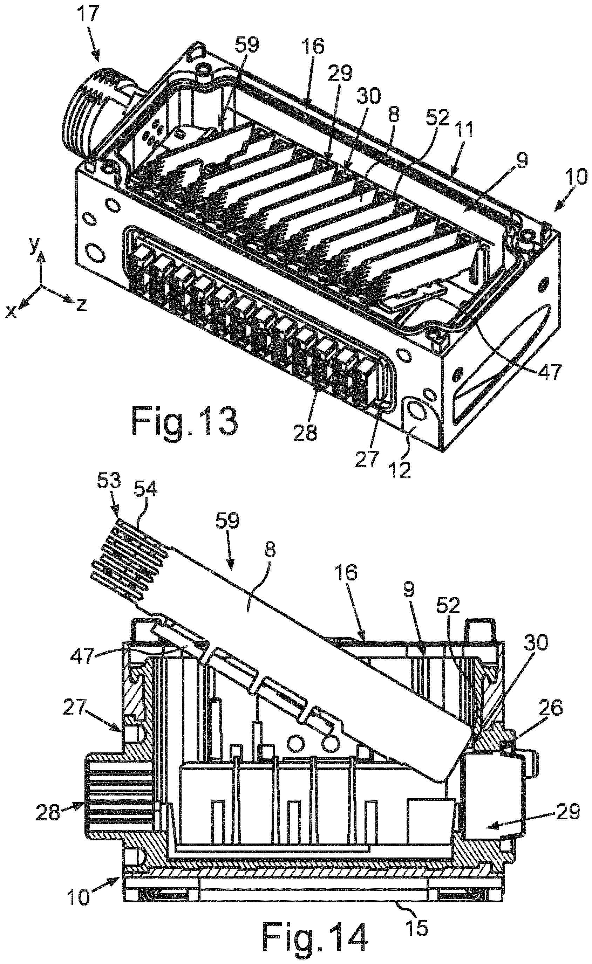

Ist diese Einsatzbaugruppe 59 vormontiert, wird sie dann im Nachfolgenden, wie dies in Fig. 13 gezeigt ist, im weiteren Montageverfahren über die Anbindungsöffnung 16 von oben in das Innere 9 des Gehäuses 10 eingeführt. Dazu wird gemäß der Darstellung in Fig. 13 und in der Schnittdarstellung in Fig. 14 die Einsatzbaugruppe 59 in einer Schrägstellung von oben eingeführt, wobei hier die ersten Enden 52 der Verkettungskontakte 8 zuerst in das Innere 9 eingeführt werden. Diese ersten Enden 52 werden dann von oben über die offenen Enden 30 der ersten Aufnahmeschlitze 29 in diese ersten Aufnahmeschlitze 29 eingefädelt, bis die ersten Enden 52 in Höhenrichtung an einer Position angekommen sind, durch welche sie durch die erste Durchführungsöffnung 26 aus dem Gehäuse 10 nach außen geschoben werden können. Wie insbesondere in Fig. 14, die eine Schnittdarstellung in der x-y-Ebene darstellt, zu erkennen ist, ist die Breite b1 der Verkettungskontakte 8 derart, dass eine reine geradlinige Einsenkung ausschließlich in y-Richtung in das Innere 9 nicht ermöglicht ist, ohne dass eine Schrägstellung der Einsatzbaugruppe 59 vorgenommen werden würde.

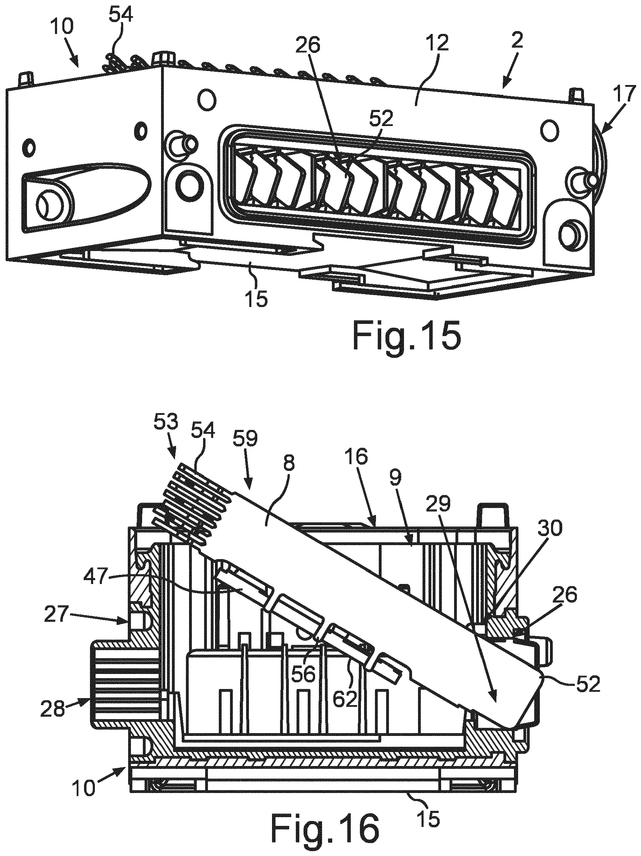

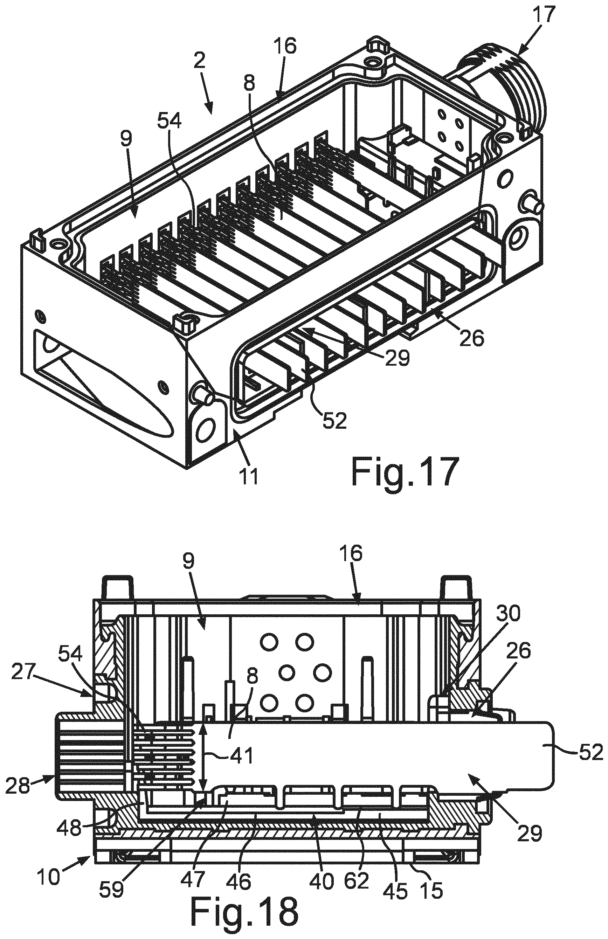

Ist dann diese abgesenkte Position der Einsatzbaugruppe 59 erreicht, in der die ersten Enden 52 durch die erste Durchführungsöffnung 26 hindurchgesteckt werden können, wird dies gemäß den Darstellungen in Fig. 14 und 15 vollzogen. Dabei wird gleichzeitig eine Schwenkbewegung nach unten vollzogen und die ersten Enden 52 durch die erste Durchführungsöffnung 26 nach außen geschoben. Das diesbezügliche nach außen Schieben erfolgt über ein derartiges Maß beziehungsweise über einen derartigen Weg, sodass die Verkettungskontakte 8, wie dies in Fig. 15 und 16 und dann insbesondere Fig. 17 und 18 dargestellt ist, weiter aus diesen ersten Durchführungsöffnungen 26 nach außen stehen, als dann in der Endlage der Einsatzbaugruppe 59 in dem Gehäuse 10.

Gemäß der Darstellung in Fig. 17 und 18, die eine Schnittdarstellung in der x-y-Ebene von Fig. 17 zeigt, zu erkennen ist, ist hier eine Zwischenlage beziehungsweise eine Zwischenmontagelage der Einbaugruppe 59 erreicht. In dieser ist das nach unten Schwenken der Einsatzbaugruppe 59 abgeschlossen und die Einsatzbaugruppe 59 vollständig im Inneren 9 angeordnet. Es ist dabei vorgesehen, dass der Schaltungsträger 47 auf Anschlag zu den ersten Aufnahmeschlitzen 29 geschoben ist und somit in seinem schmalen Seitenrand an diesem die Aufnahmeschlitze 29 umfassenden Randbereich der Trägervorrichtung 25 angestoßen ist. In dieser Zwischenlage ist die Anordnung der Verkettungskontakte 8 derart, dass die zweiten Enden 53 vollständig außerhalb der zweiten Aufnahmeschlitze 28 und auch der zweiten Durchführungsöffnung 27 im Inneren 9 angeordnet sind.

Wie zu erkennen ist, ist in dieser Zwischenlage der Schaltungsträger 47 praktisch schon horizontal angeordnet und die Verkettungskontakte 8 sind bezüglich ihrer Höhenlage im Inneren 9 derart positioniert, dass sie mit ihrer Höhe h1 vollständig (in Höhenrichtung betrachtet) innerhalb der Höhe der zweiten Aufnahmeschlitze 28 und auch der zweiten Durchführungsöffnung 27 angeordnet sind.

Darüber hinaus ist auch zu erkennen, dass der Schaltungsträger 47 mit seiner Unterseite 62 auf der ersten Erhöhung 45 aufsitzt. Zumindest in dieser Zwischenmontagelage ist durch die Querstreben 40 bis 44 die definierte Höhenlagevorgabe für die Einsatzbaugruppe 59 erzielt.

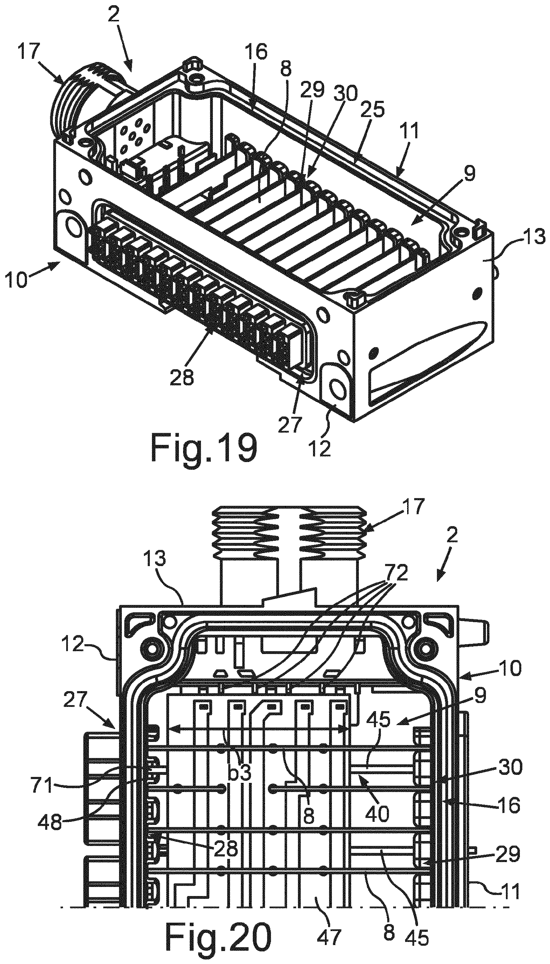

Ausgehend von dieser erreichten Zwischenmontageposition wird dann im Nachfolgenden, wie dies in Fig. 19 und 20 dargelegt ist, eine Verschiebung der Einsatzbaugruppe 59 in horizontaler Richtung zu den zweiten Durchführungsöffnungen 27 hin durchgeführt. Dies erfolgt so weit, bis die Einsatzbaugruppe 59 ihre Endposition in dem Gehäuse 10 erreicht hat. Dies ist dann gegeben, wenn der Schaltungsträger 47 von der ersten Erhöhung 45 heruntergeschoben ist und vollständig in der Auflagelänge 46 auf den Querstreben 40 bis 44 aufliegt. In dieser Endposition liegt der Schaltungsträger 47 dann nicht mehr auf der ersten Erhöhung 45 und auch nicht auf der zweiten Erhöhung 48 auf, sondern wird von diesen beiden Erhöhungen 45 und 48 seitlich eingefasst. Diese Endposition ist dann in Fig. 19 und Fig. 20, die eine Draufsicht von Fig. 19 in einem Teilausschnitt zeigt, erreicht.

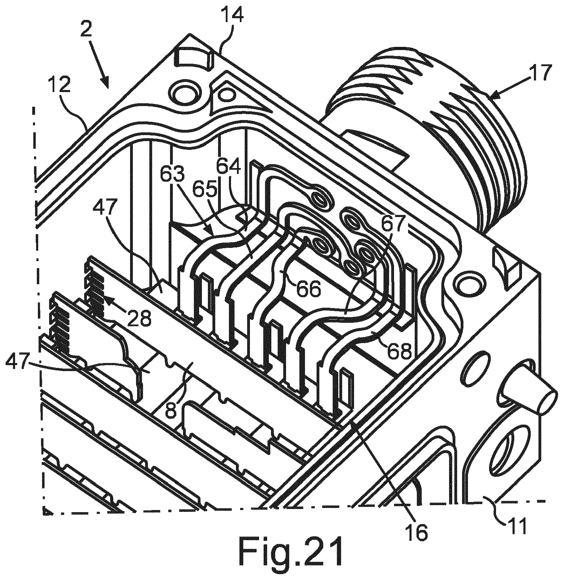

In Fig. 21 ist dann in einer perspektivischen Darstellung von oben ein Teilausschnitt des Energieversorgungsmoduls 2 gezeigt. Hier ist in einem weiteren Montagestadium dann ausgehend von dem erreichten Zustand in Fig. 19 und Fig. 20 ein Stanzgitter 63 eingebracht, welches eine Mehrzahl von Stanzgitterkontakten 64, 65, 66, 67 und 68 aufweist, die mechanisch miteinander verbunden sind, sodass ein einstückiges Stanzgitter 63 realisiert ist. Die fünf Stanzgitterkontakte 64 bis 68 sind im Ausführungsbeispiel aufgrund des fünfpoligen Anschlusses des Energieversorgungsanschlusses 17 vorgesehen. Wie in Fig. 21 zu erkennen ist, werden diese Stanzgitterkontakte 64 bis 68 in wiederum vorgesehene Kontaktlöcher im Schaltungsträger 47 eingebracht, insbesondere kann dies durch ein Widerstandsschweißen oder ein Einpressen, insbesondere mit einem nachfolgenden Verlöten, erfolgen. Auch hier ist eine gasdichte Kontaktierung zwischen den Stanzgitterkontakten 64 bis 68 und dem Schaltungsträger 47 ausgebildet.

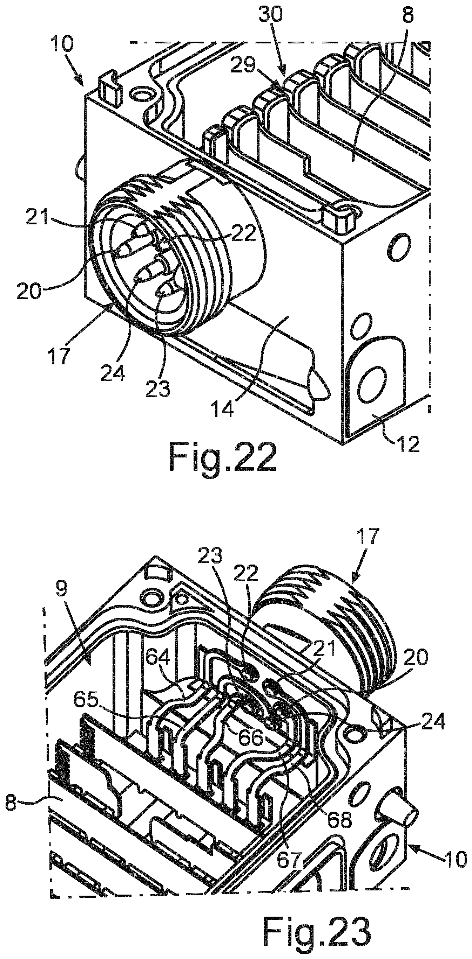

In einem nachfolgenden Verfahrensschritt wird dann gemäß der Darstellung in Fig. 22 das Anbringen der Energieversorgungskontakte 20 bis 24 durchgeführt. Dies kann ebenfalls durch ein Verpressen mit den in Fig. 22 an den oberen Enden mit Aufnahmelöchern versehenen Stanzgitterkontakten 64 bis 68 erfolgen.

Ist dieser Montagezustand erreicht, werden die Stanzgitterkontakte 64 bis 68 voneinander mechanisch getrennt und somit das Stanzgitter 63 praktisch aufgelöst. Wie in Fig. 21 und 23 zu erkennen ist, sind auch entsprechende Aufnahmen in der Trägervorrichtung 25 ausgebildet, in denen die Stanzgitterkontakte 64 bis 68 eingesetzt sind und geführt sind beziehungsweise mechanisch gehalten sind.

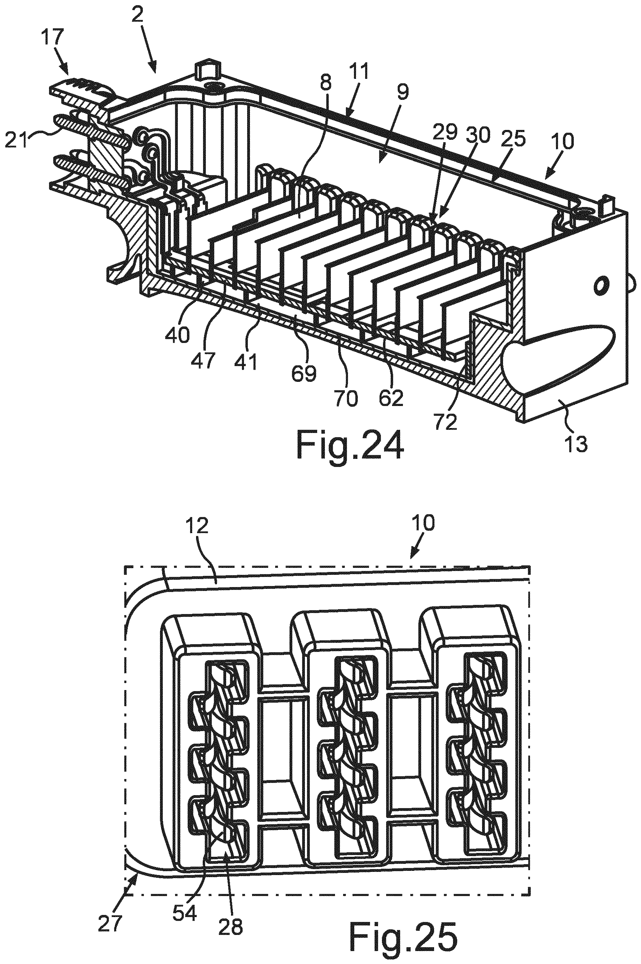

In Fig. 24 ist in einer perspektivischen Schnittdarstellung das Energieversorgungsmodul 2 im Montagezustand, wie er nach Fig. 23 erreicht ist, gezeigt. Es ist dabei zu erkennen, dass der Schaltungsträger 47 auf den Querstreben 40 bis 44 im Bereich deren Auflagelängen 46 aufsitzt. Es ist dann zwischen einem Boden 69 der Trägervorrichtung 25 und der Unterseite 62 des Schaltungsträgers 47 ein Freiraum 70 gebildet. In dem können sich dann die Kontaktstifte 56 hineinerstrecken. Von besonderer Vorteilhaftigkeit ist dieser Freiraum 70 auch dahingehend, dass eine nachfolgend noch einzubringende Vergussmasse sich nicht nur im Bereich der Verkettungskontakte 8 in den Schaltungsträger 47 bewegen kann, sondern auch in diese Freiräume 70 eingebracht werden kann, sodass der Schaltungsträger 47 umfänglich durch die Vergussmasse vergossen ist. Des Weiteren sind stegartige Positionieranschläge 72 an der Seitenwand 13 bzw. der Trägervorrichtung 25 gezeigt.

In Fig. 25 ist in einer vergrößerten Darstellung ein Ausschnitt des Energieversorgungsmoduls 2 im Bereich der zweiten Seitenwand 12 gezeigt. Es ist hier die Endposition der Kontaktfinger 54 und deren alternierend gebogene Anordnung der Laschen 58 zu erkennen.

## Patentansprüche

1. Verfahren zur Montage eines elektrischen Verkettungsmoduls (2) für ein pneumatisches Ventilsystem, bei welchem ein eckiges Gehäuse (10) des Verkettungsmoduls (2) mit einer in einer Gehäuseseite ausgebildeten Anbindungsöffnung (16) zur Anbindung für ein zum Verkettungsmodul (2) separates elektrisches Funktionsmodul (3) bereitgestellt wird, und bei welchem eine Mehrzahl von Verkettungskontakten (8), welche zur Verkettung des Verkettungsmoduls (2) mit zumindest einem weiteren Verkettungsmodul (2) ausgebildet sind, in dem Gehäuse (10) verbaut werden,
**dadurch gekennzeichnet, dass**
die Verkettungskontakte (8) außerhalb des Gehäuses (10) an einem Schaltungsträger (47) montiert werden und dadurch außerhalb des Gehäuses (10) eine vormontierte Einsatzbaugruppe (59) ausgebildet wird, welche über die Anbindungsöffnung (16) in das Gehäuse (10) eingesetzt wird, so dass in der Endposition der Einsatzbaugruppe (59) im Inneren (9) des Gehäuses (10) sich Verkettungskontakte (8) durch zumindest eine erste Durchführöffnung (26) in einer ersten Seitenwand (11) des Gehäuses (10) nach außen erstrecken und durch zumindest eine zweite Durchführöffnung (27) in einer zur ersten gegenüberliegenden zweiten Seitenwand (12) des Gehäuses (10) nach außen erstrecken, wobei die Einsatzbaugruppe (59) in einer Schrägstellung, in welcher erste Enden (52) der Verkettungskontakte (8) zuerst in die Anbindungsöffnung (16) eintauchend eingeführt werden, durch die Anbindungsöffnung (16) geführt wird und durch die Schrägstellung die ersten Enden (52) in erste Aufnahmeschlitze (29) einer zur Aufnahme der Verkettungskontakte (8) ausgebildeten Trägervorrichtung (25) in dem Gehäuse (10) eingeführt werden, wobei dazu diese ersten Aufnahmeschlitze (29) mit in Richtung der Anbindungsöffnung (16) orientierte geradlinige erste Aufnahmeschlitze (29) zum Hindurcherstrecken und Führen jeweils eines Verkettungskontakts (8) ausgebildet werden, wobei die im Bereich der ersten Seitenwand (11) des Gehäuses (10) angeordneten ersten Aufnahmeschlitze (29) in ihrer Höhenerstreckung betrachtet an ihren der Anbindungsöffnung (16) zugewandten oberen Enden (30) offen ausgebildet sind und die ersten Enden (52) der Verkettungskontakte (8) über diese oberen Ende (30) eingefädelt werden.

2. Verfahren nach Anspruch 1,
**dadurch gekennzeichnet, dass**
die Einsatzbaugruppe (59) soweit eingefädelt wird, dass sich die ersten Enden (52) der Verkettungskontakte (8) durch die zumindest eine erste Durchführöffnung (26) in einer Zwischendurchführstellung weiter nach außen erstrecken, als sie sich dann in der Endposition der Einsatzbaugruppe (59) im Gehäuse (10) nach außen erstrecken.

3. Verfahren nach Anspruch 2,
**dadurch gekennzeichnet, dass**
nach Erreichen der Zwischendurchführstellung die Einsatzbaugruppe (59) in das Gehäuse (10) vollständig durch die Anbindungsöffnung (16) in eine Zwischenlage eingeschwenkt wird bis zweite Enden (53) der Verkettungskontakte (8) auf Höhe der zumindest einen zweiten Durchführöffnung (27) positioniert sind.

4. Verfahren nach Anspruch 3,
**dadurch gekennzeichnet, dass**
die Einsatzbaugruppe (59) ausgehend von der Zwischenlage im Inneren (9) des Gehäuses (10) in Richtung der zweiten Durchführöffnung (27) des Gehäuses (10) so weit in Richtung der Erstreckung der Verkettungskontakte (8) verschoben wird, bis sich die zweiten Enden (53) der Verkettungskontakte (8) durch die zweite Durchführöffnung (27) hindurch nach außen erstrecken und die Endposition der Einsatzbaugruppe (59) erreicht wird.

5. Verfahren nach einem der vorhergehenden Ansprüche ,
**dadurch gekennzeichnet, dass**
der Schaltungsträger (47) zumindest zweitweise bei der Montage der Einsatzbaugruppe (59) in die Endposition auf Querstreben (40 bis 44), die sich zwischen der ersten (11) und der zweiten Seitenwand (12) unterhalb der Einsatzbaugruppe (59) in dem Gehäuse (10) erstrecken aufgesetzt wird.

6. Verfahren nach Anspruch 5,
**dadurch gekennzeichnet, dass**
zumindest eine Querstrebe (40 bis 44) auf Ihrem der Anbindungsöffnung (16) zugewandten oberen Rand mit einer ersten Erhöhung (45) ausgebildet wird, die sich entlang der Erstreckung der Querstrebe (40 bis 44) über eine derart kürzere Länge erstreckt, dass die restliche Auflagelänge (46) der Querstrebe (40 bis 44) größer als die Breite (b3) des Schaltungsträgers (47), jedoch maximal um 1% größer als die Breite (b3) des Schaltungsträgers (47) ist, und die Einsatzbaugruppe (59) beim Verschwenken in das Gehäuse (10) und beim Verschieben der Einsatzbaugruppe (59) zum Durchführen der zweiten Enden (53) der Verkettungskontakte (8) durch die zweite Durchführöffnung (27) auf dieser erste Erhöhung (45) aufgesetzt wird und dadurch geführt wird.

7. Verfahren nach Anspruch 6,
**dadurch gekennzeichnet, dass**
beim Verschieben der Einsatzbaugruppe (59) der Schaltungsträger (47) soweit verschoben wird, bis er von der ersten Erhöhung (45) heruntergeschoben ist, und mit dem Erreichen der Endposition der Einsatzbaugruppe (59) in dem Gehäuse (10) nur noch auf der Auflagelänge (46) der Querstrebe (40 bis 44) aufliegt, so dass der Schaltungsträger (47) durch die erste Erhöhung (45) in seiner Endposition seitlich gehalten wird.

8. Verfahren nach Anspruch 7,
**dadurch gekennzeichnet, dass**
die Auflagelänge (46) an ihrem der ersten Erhöhung (45) gegenüberliegenden Ende mit einer zweiten an dem oberen Rand der Querstrebe (40 bis 44) ausgebildeten Erhöhung (48) begrenzt wird, so dass der Schaltungsträger (47) schwimmend in der Auflagelänge (46) auf der Querstrebe (40 bis 44) gelagert wird.

9. Verfahren nach Anspruch 7 oder 8,
**dadurch gekennzeichnet, dass**
der Schaltungsträger (47) nach dem Erreichen seiner Endposition mit einer Vergussmasse umgeben wird, die auch in einen durch die Querstrebe (40 bis 44) erzeugten Freiraum (70) zwischen dem Schaltungsträger (47) und einem der Anbindungsöffnung (16) gegenüberliegenden Boden (15) des Gehäuses (10) eingebracht wird.

10. Verfahren nach einem der vorhergehenden Ansprüche,
**dadurch gekennzeichnet, dass**
das Verkettungsmodul als Energieversorgungsmodul (2) ausgebildet wird und an dem Gehäuse (10) ein Energieversorgungsanschluss (17) mit Energieversorgungskontakten (20 bis 24) ausgebildet wird, wobei nach dem Erreichen der Endposition der Einsatzbaugruppe (59) in dem Gehäuse (10) ein Stanzgitter (63) in das Gehäuse (10) eingesetzt wird, mit welchem der Schaltungsträger (47) mit dem Energieversorgungsanschluss (17) verbunden wird, insbesondere dass die Energieversorgungskontakte (20 bis 24) nach dem Einbringen des Stanzgitters (63) an dem Energieversorgungsanschluss (17) montiert und mit dem Stanzgitter (63) verbunden werden.

11. Verfahren nach einem der vorhergehenden Ansprüche,
**dadurch gekennzeichnet, dass**
die Verkettungskontakte (8) mit Kontaktstiften (56) in Kontaktlöcher (51) des Schaltungsträgers (47) eingeführt werden, insbesondere eingepresst werden und/oder verlötet werden, und dadurch die Verkettungskontakte (8) an dem Schaltungsträger (47) befestigt werden.

12. Verfahren nach einem der vorhergehenden Ansprüche,
**dadurch gekennzeichnet, dass**
eine Trägervorrichtung (25) zum Halten der Einsatzbaugruppe (59) mit ersten und zweiten Aufnahmeschlitzen (29, 28) und zumindest einer Querstrebe (40 bis 44) als einstückiger Einsatz ausgebildet wird, insbesondere als einstückige Wanne aus Kunststoff ausgebildet wird, die als separates Bauteil in das Gehäuse (10) eingesetzt wird.

13. Verfahren nach einem der vorhergehenden Ansprüche,
**dadurch gekennzeichnet, dass**
an dem zweiten Ende (53) der Verkettungskontakte (8) zumindest 7 Kontaktfinger (54) integriert ausgebildet werden, die an vorderen Enden gebogen sind, wobei beim Verbringen der Einsatzbaugruppe (59) in die Endposition in dem Gehäuse (10) jeder der Kontaktfinger (54) in einem von 7 Seitenöffnungen in einem zweiten Aufnahmeschlitz (28) eingesteckt wird.

14. Elektrisches Verkettungsmodul (2),
- mit einem eckigen Gehäuse (10) mit einer in einer Gehäuseseite ausgebildeten Anbindungsöffnung (16) zur Anbindung für ein zum Verkettungsmodul (2) separaten elektrischen Funktionsmodul (3),
- mit einer Mehrzahl von Verkettungskontakten (8), welche zur Verkettung des Verkettungsmoduls (2) mit zumindest einem weiteren Verkettungsmodul (2) ausgebildet sind und in dem Gehäuse (10) verbaut sind,
**dadurch gekennzeichnet, dass**
- die Verkettungskontakte (8) an einem Schaltungsträger (47) montiert sind und dadurch eine vormontierte Einsatzbaugruppe (59) ausgebildet ist, welche in das Gehäuse (10) eingesetzt ist, so dass in der Endposition der Einsatzbaugruppe (59) im Inneren (9) des Gehäuses (10) sich Verkettungskontakte (8) durch zumindest eine erste Durchführöffnung (26) in einer ersten Seitenwand (11) des Gehäuses (10) nach außen erstrecken und durch zumindest eine zweite Durchführöffnung (27) in einer zur ersten gegenüberliegenden zweiten Seitenwand (12) des Gehäuses (10) nach außen erstrecken,
- wobei erste Enden (52) der Verkettungskontakte (8) in erste Aufnahmeschlitze (29) einer zur Aufnahme der Verkettungskontakte (8) ausgebildeten Trägervorrichtung (25) in dem Gehäuse (10) eingeführt sind,
- wobei dazu diese ersten Aufnahmeschlitze (29) in Richtung der Anbindungsöffnung (16) orientiert und geradlinig zum Hindurcherstrecken und Führen jeweils eines Verkettungskontakts (8) ausgebildet sind, und
- die im Bereich der ersten Seitenwand (11) des Gehäuses (10) angeordneten ersten Aufnahmeschlitze (29) in ihrer Höhenerstreckung betrachtet an ihren der Anbindungsöffnung (16) zugewandten oberen Enden (30) offen ausgebildet sind und die ersten Enden (52) der Verkettungskontakte (8) über diese oberen Ende (30) eingefädelt sind,
- und die Einsatzbaugruppe (59) in der Endposition bezüglich der Anbindungsöffnung (16), insbesondere vollständig versenkt, im Inneren (9) des Gehäuses (10) angeordnet ist.

## Claims

1. A method for mounting an electrical linking module (2) for a pneumatic valve system, in which a cornered housing (10) of the linking module (2) with a connection opening (16) formed in a housing side for connecting to an electrical function module (3) separate from the linking module (2) is provided, and in which a plurality of linking contacts (8), which are formed for linking the linking module (2) to at least one further linking module (2) are installed in the housing (10),
**characterized in that**
the linking contacts (8) are mounted on a circuit board (47) outside of the housing (10) and thereby a pre-mounted insertion assembly (59) is formed outside of the housing (10), which is inserted into the housing (10) via the connection opening (16), such that linking contacts (8) extend outwards through at least one first feed-through opening (26) in a first sidewall (11) of the housing (10) in the final position of the insertion assembly (59) in the interior (9) of the housing (10) and extend outwards through at least one second feed-through opening (27) in a second sidewall (12) of the housing (10) opposing the first one, wherein the insertion assembly (59) is fed through the connection opening (16) in an inclined position, in which first ends (52) of the linking contacts (8) are first introduced into the connection opening (16) in immersing manner and the first ends (52) are introduced into first receiving slots (29) of a support device (25) formed for receiving the linking contacts (8) in the housing (10) by the inclined position, wherein these first receiving slots (29) are thereto formed with straight first receiving slots (29) oriented in the direction of the connection opening (16) for extending through and guiding each one linking contact (8), wherein the first receiving slots (29) arranged in the area of the first sidewall (11) of the housing (10) are formed open at their ends (30) facing the connection opening (16) viewed in their height extension and the first ends (52) of the linking contacts (8) are threaded via these upper ends (30).

2. The method according to claim 1,
**characterized in that**
the insertion assembly (59) is threaded as far as the first ends (52) of the linking contacts (8) extend farther outwards through the at least one first feed-through opening (26) in an intermediate feed-through position than they then extend outwards in the final position of the insertion assembly (59) in the housing (10).

3. The method according to claim 2,
**characterized in that**
after reaching the intermediate feed-through position, the insertion assembly (59) is completely swiveled into the housing (10) into an intermediate position through the connection opening (16) until second ends (53) of the linking contacts (8) are positioned at the level of the at least one second feed-through opening (27).

4. The method according to claim 3,
**characterized in that**
the insertion assembly (59) is shifted in the direction of the second feed-through opening (27) of the housing (10) starting from the intermediate position in the interior (9) of the housing (10) as far in the direction of the extension of the linking contacts (8) as the second ends (53) of the linking contacts (8) extend outwards through the second feed-through opening (27) and the final position of the insertion assembly (59) is reached.

5. The method according to any one of the preceding claims,
**characterized in that**
the circuit board (47) is at least temporarily fitted onto transverse struts (40 to 44), which extend between the first (11) and the second sidewall (12) below the insertion assembly (59) in the housing (10), upon mounting the insertion assembly (59) in the final position.

6. The method according to claim 5,
**characterized in that**
at least one transverse strut (40 to 44) is formed with a first elevation (45) at its upper edge facing the connection opening (16), which extends along the extension of the transverse strut (40 to 44) over a shorter length such that the remaining support length (46) of the transverse strut (40 to 44) is larger than the width (b3) of the circuit board (47), but larger than the width (b3) of the circuit board (47) by a maximum of 1 %, and upon swiveling into the housing (10) and upon shifting the insertion assembly (59) for feeding the second ends (53) of the linking contacts (8) through the second feed-through opening (27), the insertion assembly (59) is fitted onto this first elevation (45) and thereby guided.

7. The method according to claim 6,
**characterized in that**
upon shifting the insertion assembly (59), the circuit board (47) is shifted as far as it is shifted down from the first elevation (45), and with reaching the final position of the insertion assembly (59) in the housing (10), only rests on the support length (46) of the transverse strut (40 to 44) such that the circuit board (47) is laterally retained in its final position by the first elevation (45).

8. The method according to claim 7,
**characterized in that**
the support length (46) is bounded by a second elevation (48) formed at the upper edge of the transverse strut (40 to 44) at its end opposing the first elevation (45), such that the circuit board (47) is supported on the transverse struct (40 to 44) in the support length (46) in floating manner.

9. The method according to claim 7 or 8,
**characterized in that**
the circuit board (47) is surrounded by a casting compound after reaching its final position, which is also introduced into a clearance (70) generated by the transverse strut (40 to 44) between the circuit board (47) and a bottom (15) of the housing (10) opposing the connection opening (16).

10. The method according to any one of the preceding claims,
**characterized in that**
the linking module is formed as an energy supply module (2) and an energy supply terminal (17) with energy supply contacts (20 to 24) is formed at the housing (10), wherein after reaching the final position of the insertion assembly (59) in the housing (10), a lead frame (63) is inserted into the housing (10), by which the circuit board (47) is connected to the energy supply terminal (17), in particular that the energy supply contacts (20 to 24) are mounted on the energy supply terminal (17) and connected to the lead frame (63) after inserting the lead frame (63).

11. The method according to any one of the preceding claims,
**characterized in that**
the linking contacts (8) are introduced, in particular press-fitted and/or soldered, into contact holes (51) of the circuit board (47) with contact pins (56), and thereby the linking contacts (8) are attached to the circuit board (47).

12. The method according to any one of the preceding claims,
**characterized in that**
the support device (25) is formed as an integral insert with first and second receiving slots (28, 29) and at least one transverse strut (40 to 44) for retaining the insertion assembly (59), in particular is formed as an integral trough of plastic, which is inserted into the housing (10) as a separate component.

13. The method according to any one of the preceding claims,
**characterized in that**
at least 7 contact fingers (54) are formed integrated at the second end (53) of the linking contacts (8), which are bent at front ends, wherein each of the contact fingers (54) is plugged into one of 7 side openings in a second receiving slot (28) upon bringing the insertion assembly (59) into the final position in the housing (10).

14. An electrical linking module (2),
- including a cornered housing (10) with a connection opening (16) formed in a housing side for connecting to an electrical function module (3) separate from the linking module (2),
- including a plurality of linking contacts (8), which are formed for linking the linking module (2) to at least one further linking module (2) and installed in the housing (10),
**characterized in that**
- the linking contacts (8) are mounted on a circuit board (47) and thereby a pre-mounted insertion assembly (59) is formed, which is inserted into the housing (10) such that in the final position of the insertion assembly (59) in the interior (9) of the housing (10), linking contacts (8) extend outwards through at least one first feed-through opening (26) in a first sidewall (11) of the housing (10) and extend outwards through at least one second feed-through opening (27) in a second sidewall (12) of the housing (10) opposing to the first one,
- wherein first ends (52) of the linking contacts (8) are introduced into first receiving slots (29) of a support device (25) formed for receiving the linking contacts (8) in the housing (10),
- wherein these first receiving slots (29) are thereto oriented in the direction of the connection opening (16) and are formed straight for extending through and guiding each one linking contact (8), and
- the first receiving slots (29) arranged in the area of the first sidewall (11) of the housing (10) are formed open at their upper ends (30) facing the connection opening (16) viewed in their height extension, and the first ends (52) of the linking contacts (8) are threaded via these upper ends (30),
- and the insertion assembly (59) is arranged, in particular completely recessed, in the interior (9) of the housing (10) with respect to the connection opening (16) in the final position.

## Revendications

1. Procédé de montage d'un module de chaînage (2) électrique pour un système de valves pneumatique, avec lequel est fourni un boîtier (10) polygonal du module de chaînage (2) muni d'une ouverture de rattachement (16) formée dans un côté de boîtier destinée au rattachement pour un module fonctionnel (3) électrique séparé du module de chaînage (2), et avec lequel une pluralité de contacts de chaînage (8), lesquels sont configurés pour le chaînage du module de chaînage (2) avec au moins un module de chaînage (2) supplémentaire, sont installés dans le boîtier (10),
**caractérisé en ce que**
les contacts de chaînage (8) sont montés à l'extérieur du boîtier (10) sur un porte-circuit (47) et un sous-ensemble d'insertion (59) prémonté est ainsi formé à l'extérieur du boîtier (10), lequel est inséré dans le boîtier (10) par le biais de l'ouverture de rattachement (16), de sorte que dans la position finale du sous-ensemble d'insertion (59) à l'intérieur (9) du boîtier (10), des contacts de chaînage (8) s'étendent vers l'extérieur à travers au moins une première ouverture de passage (26) dans une première paroi latérale (11) du boîtier (10) et s'étendent vers l'extérieur à travers au moins une deuxième ouverture de passage (27) dans une deuxième paroi latérale (12) du boîtier (10) opposée à la première, le sous-ensemble d'insertion (59) étant guidé à travers l'ouverture de rattachement (16) dans une position inclinée, dans laquelle des premières extrémités (52) des contacts de chaînage (8) sont tout d'abord introduites par enfoncement dans l'ouverture de rattachement (16), et les premières extrémités (52), par la position inclinée, sont introduites dans des premières fentes d'accueil (29) d'un dispositif porteur (25) dans le boîtier (10) destiné à accueillir les contacts de chaînage (8), ces premières fentes d'accueil (29) étant à cet effet configurées avec des premières fentes d'accueil (29) rectilignes orientées en direction de l'ouverture de rattachement (16) destinées à être traversées par et à guider respectivement un contact de chaînage (8), les premières fentes d'accueil (29) disposées dans la zone de la première paroi latérale (11) du boîtier (10), vues dans leur projection en hauteur, étant configurées ouvertes au niveau de leurs extrémités supérieures (30) qui font face à l'ouverture de rattachement (16) et les premières extrémités (52) des contacts de chaînage (8) étant enfilés par cette extrémité supérieure (30).

2. Procédé selon la revendication 1, **caractérisé en ce que** le sous-ensemble d'insertion (59) est enfilé jusqu'à ce que les premières extrémités (52) des contacts de chaînage (8) à travers l'au moins une première ouverture de passage (26) dans une position de traversée intermédiaire s'étendent davantage vers l'extérieur qu'elles s'étendent ensuite vers l'extérieur dans la position finale du sous-ensemble d'insertion (59) dans le boîtier (10).

3. Procédé selon la revendication 2, **caractérisé en ce qu'**après avoir atteint la position de traversée intermédiaire, le sous-ensemble d'insertion (59) est entièrement introduit par pivotement dans le boîtier (10) à travers l'ouverture de rattachement (16) dans une position intermédiaire jusqu'à ce que des deuxièmes extrémités (53) des contacts de chaînage (8) soient positionnées à hauteur de l'au moins une deuxième ouverture de passage (27).

4. Procédé selon la revendication 3, **caractérisé en ce que** le sous-ensemble d'insertion (59), à partir de la position intermédiaire à l'intérieur (9) du boîtier (10) en direction de la deuxième ouverture de passage (27) du boîtier (10), est glissé en direction de la projection des contacts de chaînage (8) jusqu'à ce que les deuxièmes extrémités (53) des contacts de chaînage (8) s'étendent vers l'extérieur à travers la deuxième ouverture de passage (27) et que la position finale du sous-ensemble d'insertion (59) soit atteinte.

5. Procédé selon l'une des revendications précédentes, **caractérisé en ce que** le porte-circuit (47) est posé, au moins temporairement lors du montage du sous-ensemble d'insertion (59) dans la position finale, sur des nervures transversales (40 à 44) qui s'étendent entre la première (11) et la deuxième paroi latérale (12) au-dessous du sous-ensemble d'insertion (59) dans le boîtier (10) .

6. Procédé selon la revendication 5, **caractérisé en ce qu'**au moins une nervure transversale (40 à 44) est configurée avec un premier bossage (45) sur son bord supérieur qui fait face à l'ouverture de rattachement (16), lequel s'étend le long de la projection de la nervure transversale (40 à 44) sur une longueur plus courte de sorte que la longueur d'appui (46) restante de la nervure transversale (40 à 44) est supérieure à la largeur (b3) du porte-circuit (47), toutefois au maximum 1 % supérieure à la largeur (b3) du porte-circuit (47), et le sous-ensemble d'insertion (59), lors du pivotement dans le boîtier (10) et lors du décalage du sous-ensemble d'insertion (59) en vue de faire passer les deuxièmes extrémités (53) des contacts de chaînage (8) à travers la deuxième ouverture de passage (27), repose sur ce premier bossage (45) et est ainsi guidé.

7. Procédé selon la revendication 6, **caractérisé en ce que** lors du décalage du sous-ensemble d'insertion (59), le porte-circuit (47) est décalé jusqu'à ce qu'il soit descendu du premier bossage (45), et lorsque la position finale du sous-ensemble d'insertion (59) dans le boîtier (10) est atteinte, il ne repose plus que sur la longueur d'appui (46) de la nervure transversale (40 à 44), de sorte que le porte-circuit (47) est maintenu latéralement dans sa position finale par le premier bossage (45).

8. Procédé selon la revendication 7, **caractérisé en ce que** la longueur d'appui (46) est délimitée à son extrémité à l'opposé du premier bossage (45) par un deuxième bossage (48) formé au niveau du bord supérieur de la nervure transversale (40 à 44), de sorte que le porte-circuit (47) est monté flottant sur la nervure transversale (40 à 44) dans la longueur d'appui (46).

9. Procédé selon la revendication 7 ou 8, **caractérisé en ce que** le porte-circuit (47), après avoir atteint sa position finale, est entouré d'une masse de scellement qui est également introduite dans un espace libre (70) généré par la nervure transversale (40 à 44) entre le porte-circuit (47) et un fond (15) du boîtier (10) à l'opposé de l'ouverture de rattachement (16).

10. Procédé selon l'une des revendications précédentes, **caractérisé en ce que** le module de chaînage est réalisé sous la forme d'un module d'alimentation en énergie (2) et une borne d'alimentation en énergie (17) munie de contacts d'alimentation en énergie (20 à 24) est formée sur le boîtier (10), une grille estampée (63) étant introduite dans le boîtier (10) après que le sous-ensemble d'insertion (59) ait atteint sa position finale dans le boîtier (10), avec laquelle le porte-circuit (47) est relié à la borne d'alimentation en énergie (17), les contacts d'alimentation en énergie (20 à 24), après l'introduction de la grille estampée (63), étant notamment montés sur la borne d'alimentation en énergie (17) et reliés à la grille estampée (63).

11. Procédé selon l'une des revendications précédentes, **caractérisé en ce que** les contacts de chaînage (8) sont introduits par des broches de contact (56) dans des trous de contact (51) du porte-circuit (47), notamment enfoncés et/ou brasés, et les contacts de chaînage (8) sont ainsi fixés au porte-circuit (47).

12. Procédé selon l'une des revendications précédentes, **caractérisé en ce qu'**un dispositif porteur (25) destiné à maintenir le sous-ensemble d'insertion (59) est réalisé sous la forme d'un insert monobloc pourvu de premières et de deuxièmes fentes d'accueil (29, 28) et au moins une nervure transversale (40 à 44), notamment réalisé sous la forme d'un bac en matière plastique monobloc, qui est inséré en tant qu'élément structural séparé dans le boîtier (10).

13. Procédé selon l'une des revendications précédentes, **caractérisé en ce qu'**au moins 7 doigts de contact (54) intégrés sont formés à la deuxième extrémité (53) des contacts de chaînage (8), lesquels sont courbés aux extrémités avant, chacun des doigts de contact (54) étant introduit dans l'une de 7 ouvertures latérales dans une deuxième fente d'accueil (28) lors de l'amenée du sous-ensemble d'insertion (59) dans la position finale dans le boîtier (10).

14. Module de chaînage (2) électrique,
- comprenant un boîtier (10) polygonal muni d'une ouverture de rattachement (16) formée dans un côté de boîtier destinée au rattachement pour un module fonctionnel (3) électrique séparé du module de chaînage (2),
- comprenant une pluralité de contacts de chaînage (8), lesquels sont configurés pour le chaînage du module de chaînage (2) avec au moins un module de chaînage (2) supplémentaire et sont installés dans le boîtier (10), **caractérisé en ce que**
- les contacts de chaînage (8) sont montés sur un porte-circuit (47) et un sous-ensemble d'insertion (59) prémonté est ainsi formé, lequel est inséré dans le boîtier (10) de sorte que dans la position finale du sous-ensemble d'insertion (59) à l'intérieur (9) du boîtier (10), des contacts de chaînage (8) s'étendent vers l'extérieur à travers au moins une première ouverture de passage (26) dans une première paroi latérale (11) du boîtier (10) et s'étendent vers l'extérieur à travers au moins une deuxième ouverture de passage (27) dans une deuxième paroi latérale (12) du boîtier (10) opposée à la première,
- des premières extrémités (52) des contacts de chaînage (8) étant introduites dans des premières fentes d'accueil (29) d'un dispositif porteur (25) dans le boîtier (10) destiné à accueillir les contacts de chaînage (8),
- ces premières fentes d'accueil (29) étant à cet effet orientées en direction de l'ouverture de rattachement (16) et configurées de manière à être traversées par et à guider respectivement un contact de chaînage (8), et
- les premières fentes d'accueil (29) disposées dans la zone de la première paroi latérale (11) du boîtier (10), vues dans leur projection en hauteur, étant configurées ouvertes au niveau de leurs extrémités supérieures (30) qui font face à l'ouverture de rattachement (16) et les premières extrémités (52) des contacts de chaînage (8) étant enfilées par cette extrémité supérieure (30),
- et le sous-ensemble d'insertion (59) dans la position finale par rapport à l'ouverture de rattachement (16) étant disposé à l'intérieur (9) du boîtier (10), notamment entièrement noyé.
